# EUROPEAN PATENT SPECIFICATION

(11) **EP 3 222 435 B1**
(45) Date of publication and mention of the grant of the patent: **24.11.2021**
(21) Application number: 15861207.7
(22) Date of filing: 18.11.2015
(51) Int. Cl.: B41M 1/08, G03F 7/00, G03F 7/004, G03F 7/039, G03F 7/11, B41C 1/10, B41N 1/00

(54) **METHOD FOR MANUFACTURING PRINTED MATTER**
VERFAHREN ZUR HERSTELLUNG EINES BEDRUCKTEN MATERIALS
PROCÉDÉ DE PRODUCTION DE DOCUMENTS IMPRIMÉS

(30) Priority: 20.11.2014 JP 2014235204; 20.10.2015 JP 2015206063
(43) Date of publication of application: 27.09.2017
(73) Proprietor: Toray Industries, Inc., Tokyo 103-8666 (JP)
(72) Inventor: INOUE, Takejiro, Otsu-shi Shiga 520-8558 (JP); MURASE, Seiichiro, Otsu-shi Shiga 520-8558 (JP); TSUJI, Yuichi, Otsu-shi Shiga 520-8558 (JP); IIHARA, Akihiro, Otsu-shi Shiga 520-8558 (JP)
(74) Representative: Kador & Partner PartG mbB
(86) International application number: PCT/JP2015/082387
(87) International publication number: WO 2016/080436

(56) References cited:
- EP-A1- 2 667 251
- JP-A- H07 232 485
- JP-A- 2001 232 959
- JP-A- 2008 143 993
- JP-A- 2009 132 890
- US-A- 3 975 352
- None

## Description

### TECHNICAL FIELD

The present invention relates to a method of producing a printed material using a lithographic printing plate having an ink repelling layer and a water-based ink and a lithographic printing plate original for water-based ink.

### BACKGROUND ART

Lithographic printing is widely used as a system for high-speed supply of printed materials in large amounts at low cost. In general, in lithographic printing, dampening water is retained in a hydrophilic portion of a printing plate, thereby forming a non-imaging area and allowing an oil-based ink to adhere to an imaging area for image forming. However, in view of recent environmental problems and working environment conservation, in order to reduce the use of volatile petroleum solvents in various printing fields, the use of water-based inks has been actively studied. In the case of lithographic printing with the use of dampening water, a water-based ink and damping water are mixed, thereby theoretically making it impossible to form an image. Therefore, it has been difficult to develop water-based printing.

Meanwhile, many types of printing plates using a silicone rubber or a fluorine resin as an ink repelling layer for lithographic printing without using dampening water (hereinafter referred to as "waterless lithographic printing") have been proposed. Waterless lithographic printing is a lithographic printing method wherein a printing plate, on which an ink accepting layer that forms an imaging area and an ink repelling layer that forms a non-imaging area exist at a substantially plane level, is used, inking with an ink is conducted exclusively on the imaging area utilizing a difference in ink adhesiveness, and then the ink is transferred onto a printing substrate such as paper for printing. This method is characterized in that printing is possible without using dampening water.

For production of a lithographic printing plate, an exposure step is usually necessary, and a pre-processing step and/or a post-processing step is optionally performed before and/or after the exposure step. Methods of exposure are roughly classified into methods of performing UV irradiation through an original image film on a lithographic printing plate original and computer-to-plate methods for writing an image directly from a document without using an original image film (hereinafter referred to as "CTP"). The CTP methods include methods of irradiating with a laser beam, methods of drawing with a thermal head, methods of locally applying a voltage by a pin electrode, methods of forming an ink repellent layer or an ink accepting layer by ink jet, etc. Among them, the methods using a laser beam are superior to the other methods in resolution and processing speed. The laser beam irradiation methods can be grouped into two types: a photon mode type that utilizes photoreactions, and a heat mode type that causes heat reactions through light-to-heat conversion. In particular, with the heat mode type there is the advantage that handling is possible in a bright room and, furthermore, due to rapid advances in the semiconductor lasers which serve as the light source, recently the usefulness thereof has been becoming significant. With regard to the heat mode, a waterless lithographic printing plate original which has at least a heat sensitive layer and a silicone rubber layer in that order on a base material has been disclosed (Patent Document 1)

In addition, a lithographic printing using an improved water-based ink has already been suggested (Patent Documents 2 to 4).

Patent Document 6 discloses a directly imageable waterless lithographic printing plate precursor including at least a heat sensitive layer and a silicone rubber layer formed on a substrate in this order, wherein the heat sensitive layer contains at least a novolac resin, a polyurethane and a light-to-heat conversion material and has a phase separation structure including at least a phase containing the novolac resin and a phase containing the polyurethane.

Patent Document 7 discloses a water-based ink composition comprises (a) a pigment, (b) a binder resin exhibiting solubility or dispersibility to an aqueous solvent in the presence of a basic compound, (c) an aqueous solvent, (d) a basic compound, and (e) a hydrophilic silicone oil.

Patent Document 8 discloses a directly imageable waterless lithographic printing plate precursor comprising a repellent composition containing an oil of low volatility having a surface energy less than 27 dynes/cm. and a solid fluorinated polymer such as a polymer of a fluoroalkyl acrylate. A resinous binder and/or a particulate fluorocarbon powder may be added to the repellent composition.

### PRIOR ART REFERENCES

### PATENT DOCUMENTS

Patent Document 1: Japanese Patent Application Laid-Open Publication No. 2001-232959
Patent Document 2: Japanese Patent Application Laid-Open Publication No. 2007-177191
Patent Document 3: Japanese Patent Application Laid-Open Publication No. 2009-13345
Patent Document 4: Japanese Patent Application Laid-Open Publication No. 2008-143993
Patent Document 5: Japanese Patent Application Laid-Open Publication No. 2010-201670
Patent Document 6: EP 2 667 251 A1
Patent Document 7: JP 2009 132890 A
Patent Document 8: US 3 975 352 A

### DISCLOSURE OF THE INVENTION

### PROBLEMS TO BE SOLVED BY THE INVENTION

In the inventions of Patent Documents 2 to 4, the improved water-based inks are used; however, printing plates to be used are waterless lithographic printing plates each having an ink repelling layer that is intended to be used for oil-based inks. Ink repellency of the non-imaging area, namely an ink repelling layer, does not meet requirements of water-based inks, resulting in insufficient resistance to ink scumming.

The invention of Patent Document 5 is intended to expose a water-repelling layer containing a photocatalyst to an ultraviolet laser, which results in insufficient ink repellency. In addition, it is necessary to use an expensive ultraviolet laser, which is also problematic

An object of the invention is to overcome the problems of the prior art so as to provide a lithographic printing method, whereby even when a water-based ink is used, the water-based ink is unlikely to adhere to the ink repelling layer, thereby making it possible to obtain printed materials in large amounts.

### MEANS FOR SOLVING THE PROBLEMS

In order to achieve the above object, the invention is defined according to the claims shown below.

### EFFECT OF THE INVENTION

According to the invention, a printed material that is excellent in printing quality and environmental aspects can be obtained using a water-based ink. Specifically, a lithographic printing method that is excellent in printing quality for inking performance and repellency and environmental aspects can be provided, and a printed material can be obtained using a lithographic printing plate original for a water-based ink.

### BRIEF DESCRIPTION OF THF DRAWINGS

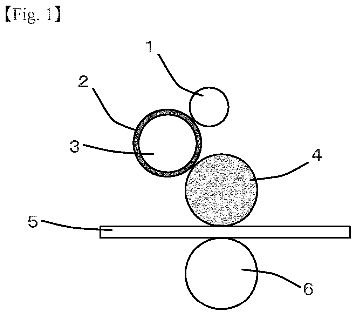

Fig. 1 is a cross-sectional view showing one embodiment of the method of producing a printed material of the invention.

### BEST MODE FOR CARRYING OUT THE INVENTION

The method of producing a printed material of the invention includes the steps of: allowing a water-based ink to adhere to a surface of a heat sensitive layer of a lithographic printing plate having at least an ink repelling layer and the heat sensitive layer on its surface; and transferring the adhering water-based ink directly or via a blanket to a printing substrate, wherein the heat sensitive layer contains a novolac resin and an organic complex compound, and the heat sensitive layer contains the novolac resin and the organic complex compound at a mass ratio of 2 to 6. Accordingly, the water-based ink does not adhere to the ink repelling layer, which prevents scumming, thereby making it possible to obtain a large amount of a printed material.

One embodiment of the method of producing a printed material of the invention is described below with reference to Fig. 1. Note that an example in which a blanket 4 is used is described below; however, the invention is not limited thereto. It is also possible to allow a water-based ink to adhere to a surface of lithographic printing plate 2 attached to a plate cylinder 3 directly from an ink roller 1 without using a blanket 4 and then to transfer the water-based ink directly to a printing substrate. In addition, an example in which a water-based ink is supplied from above a printing substrate 5 is described below; however, it is also possible to supply the water-based ink from under the printing substrate 5.

At first, a lithographic printing plate is prepared. The lithographic printing plate 2 of the invention has an ink repelling layer and a heat sensitive layer (each not shown) in a desirable pattern. The water-based ink is supplied to the ink roller 1. The water-based ink supplied to the ink roller 1 adheres to the surface of a heat sensitive layer arranged on the surface of the lithographic printing plate 2 attached to the plate cylinder 3. The water-based ink does not adhere to the ink repelling layer. The water-based ink adhering to the surface of the heat sensitive layer of the lithographic printing plate 2 is transferred to the surface of the blanket 4 at a point of contact with the blanket 4. The water-based ink adhering to the blanket 4 is transferred to the printing substrate 5 at a contact point with the printing substrate 5 arranged on a support roller 6. A printed material is obtained by drying the printing substrate 5 as necessary.

In the above production method, the speed of rotation of each roller is not limited, and therefore, it can be appropriately set depending on quality, delivery time, and ink properties required for a printed material.

The water-based ink remaining on the ink roller 1, the lithographic printing plate 2, and the blanket 4 after printing can be easily removed using water or an aqueous solution mainly consisting of water (hereinafter referred to as "washing water"). It is possible to wipe off the water-based ink with nonwoven fabric, absorbent cotton, cloth, sponge, or the like impregnated with the washing water or to apply the washing water directly to the water-based ink by spraying or the like and then wipe off them with nonwoven fabric, absorbent cotton, cloth, sponge, or the like. It is also possible to pour washing water through the ink roller 1 to pass the washing water from the lithographic printing plate 2 to the blanket 4, thereby removing the water-based ink.

It is preferable for the washing water to contain a surfactant so that wettability on the surfaces of the ink roller 1, the lithographic printing plate 2, the blanket 4, or the like is improved, thereby increasing the water-based ink removal rate. Any known surfactant can be used as the above surfactant; however, commercially available detergents for home use are preferably used from the viewpoints of safety, disposal cost, etc. The content of the surfactant in the washing water is preferably 0.1% by mass or more, more preferably 0.5% by mass or more, and particularly preferably 1.0% by mass or more in order to decrease the surface energy of the washing water. In addition, it is preferably 30% by mass or less, more preferably 20% by mass or less, and particularly preferably 10% by mass or less so that the washing water has affinity for the water-based ink. Such washing water is highly safe and preferable from the economic viewpoint in terms of disposal cost, etc. Further, when pH of the washing water is 4 to 11, the washing water is less likely to penetrate the ink roller 1, the lithographic printing plate 2, and the blanket 4, which tends to prevent the occurrence of the problem of water-based ink penetration. This is preferable.

Next, a lithographic printing plate original that can be used in the method of producing a printed material of the invention is described below. A lithographic printing plate original that can be used in the method of producing a printed material of the invention may have a base material as necessary. When it has a base material, it has at least an ink repelling layer and a heat sensitive layer on or above the base material. Either the heat sensitive layer or the ink repelling layer may be disposed close to the base material. However, it is preferable that the base material, the heat sensitive layer, and the ink repelling layer be disposed in that order.

As the base material for the lithographic printing plate original, known papers, metals, glass, and films, which are conventionally used as base materials for printing plates and have stable dimensional sizes, can be used. Specific examples include paper, plastic (e.g., polyethylene, polypropylene, or polystyrene) laminated paper, aluminum (including aluminum alloys), zinc, copper or other such metal sheet, glass plates of soda lime, quartz, and the like, silicon wafer, films of plastics material, for example, cellulose acetate, polyethylene terephthalate, polyethylene, polyester, polyamide, polyimide, polystyrene, polypropylene, polycarbonate, or polyvinyl acetal, and also paper or plastics film laminated with, or with a vapor deposited coating of, an aforesaid metal. Plastic films may be transparent or opaque. From the viewpoint of plate inspectability, opaque plastic films are preferable.

Amongst these substrates, aluminum plates are especially preferred in that they have outstanding dimensional stability and, moreover, are comparatively cheap. Again, the polyethylene terephthalate films which are employed as substrates for short-run printing are also favorably used.

Base material thickness is not particularly limited. However, the thickness corresponding to a press used for lithographic printing may be selected.

Next described will be the heat sensitive layer employed in the lithographic printing plate original. It is preferable for the heat sensitive layer of the lithographic printing plate original to function to efficiently absorb laser light used for drawing so as to convert laser light to heat (photothermal conversion) so that at least the surface of the heat sensitive layer is degraded by the generated heat, resulting in an increase in solubility in a developer or a decrease in adhesion to the ink repelling layer.

Such heat sensitive layer includes a composition containing an active hydrogen-containing polymer, an organic complex compound, and optionally a photothermal conversion material. The heat sensitive layer can be prepared by coating and drying a solution or dispersion containing such composition. Drying may be conducted at ordinary temperature or by heating. When the heat sensitive layer prepared in the above manner is irradiated with laser light, the crosslinked structure formed with the polymer and the organic complex compound is degraded by heat generated from the photothermal conversion material.

The polymer with a structural unit having active hydrogen is a novolak resin.

The active hydrogen-containing polymer can be used on their own or can be used in the form of mixtures of two or more types.

Novolak resins show good performance in terms of thermal degradability and solubility in a developer. Examples of novolak resins include phenol novolak resins and cresol novolak resins.

The content of the novolac resin is preferably 20% by mass or more and more preferably 30% by mass or more in the heat sensitive layer in order to degrade the surface of the heat sensitive layer by heat or cause the heat sensitive layer to be easily dissolved in a developer, thereby promoting development. In addition, it is preferably 95% by mass or less and more preferably 80% by mass or less in terms of brittleness of the heat sensitive layer.

The photothermal conversion material that is preferably used for the heat sensitive layer is preferably a photothermal conversion material that functions to absorb laser light, convert light energy into atomic/molecular motion energy, and instantly generate heat at 200°C or more on the surface of the heat sensitive layer, thereby thermally degrading the crosslinked structure of the heat sensitive layer. In particular, infrared- or near infrared-absorbing pigments and dyes are preferable. For example, it is preferable to use additives, for example, black pigments such as carbon black, aniline black, and cyanine black, green pigments of the phthalocyanine or naphthalocyanine type, carbon graphite, iron powder, diamine type metal complexes, dithiol type metal complexes, phenolthiol type metal complexes, mercaptophenol type metal complexes, crystal water-containing inorganic compounds, copper sulphate, chromium sulphide, silicate compounds, metal oxides such as titanium oxide, vanadium oxide, manganese oxide, iron oxide, cobalt oxide, and tungsten oxide, the hydroxides and sulphates of these metals, and metal powders of bismuth, iron, magnesium and aluminum.

In addition, as infrared- or near infrared-absorbing dyes, dyes having a maximum absorption wavelength in the range from 700 nm to 1500 nm are preferable. They are preferably dyes employed for electronics or for recording. Of these, cyanine dyes, azulenium dyes, squarilium dyes, croconium dyes, azo disperse dyes, bisazostilbene dyes, naphthoquinone dyes, anthraquinone dyes, perylene dyes, phthalocyanine dyes, naphthalocyanine metal complex dyes, polymethine type dyes, dithiolnickel complex dyes, indoaniline metal complex dyes, intermolecular CT dyes, benzothiopyran type spiropyran, and nigrosine dyes are preferably used.

From amongst these dyes, those having a large molar extinction coefficient ε are preferably used. Specifically, ε is preferably 1 x 10⁴ L/(mol·cm) or more and more preferably 1 x 10⁵L /(mol·cm) or more. When ε is 1 x 10⁴ L/(mol·cm) or more, sensitivity can be further improved. The coefficient used herein is based on active energy ray for irradiation. Specific wavelengths to be mentioned may be 780 nm, 830 nm, or 1064 nm.

Two or more of these photothermal conversion materials may be contained. By allowing the heat sensitive layer to contain two or more photothermal conversion materials with different absorption wavelengths, it is also possible to utilize with two or more types of laser with different emission wavelengths.

It is preferable for the heat sensitive layer to contain a black pigment or an infrared- or near infrared-absorbing dye selected from among the above photothermal conversion materials in view of photothermal conversion rate, economy, and handling convenience.

The photothermal conversion material content is preferably from 0.1% to 70% by mass, and more preferably from 0.5% to 40% by mass in the layer containing the photothermal conversion material. By setting the photothermal conversion material content to 0.1% by mass or more, it is possible to further improve sensitivity to laser light. Meanwhile, when the content is set to 70% by mass or less, high printing durability of the printing plate can be maintained.

The lithographic printing plate original used in the method of producing a printed material of the invention further contains an organic complex compound in the heat sensitive layer in order to improve interlayer adhesiveness through formation of the crosslinked structure. Examples of the organic complex compound mentioned herein include organic complex salts in which an organic ligand is coordinate-bonded to a metal, organic inorganic complex salts in which an organic ligand and an inorganic ligand are coordinate-bonded to a metal, and metal alkoxides in which a metal and an organic molecule are covalent-bonded via oxygen. Of these, a metal chelate compound having a donor atom with two or more coordinate groups and forming a ring structure containing a metal atom is preferably used in terms of stability of the organic complex compound itself or stability of the heat sensitive layer composition liquid.

Examples of major metals that form an organic complex compound include Cu(I), Ag(I), Hg(I), Hg(II), Li, Na, K, Be(II), B(III), Zn(II), Cd(II), Al(III), Co(II), Ni(II), Cu(II), Ag(II), Au(III), Pd(II), Pt(II), Ca(II), Sr(II), Ba(II), Ti(IV), V(III), V(IV), Cr(III), Mn(II), Mn(III), Fe(II), Fe(III), Co(III), Pd(IV), Pt(IV), Sc(III), Y(III), Si(IV), Sn(II), Sn(IV), Pb(IV), Ru(III), Rh(III), Os(III), Ir(III), Rb, Cs, Mg, Ni(IV), Ra, Zr(IV), Hf(IV), Mo(IV), W(IV), Ge, In, lanthanide, and actinide. Of these, Al, Ti, Mn, Fe, Co, Ni, Cu, Zn, Ge, In, Sn, Zr, and Hf are preferable, and Al, Ti, Fe, and Zr are more preferable. A1 is particularly preferable in that it is effective for the improvement of sensitivity. Ti is particularly preferable in that it tends to express resistance to a printing ink or ink washing agent.

In addition, examples of the ligand are compounds having coordinate groups as listed below having O (oxygen atom), N (nitrogen atom), S (sulfur atom), or the like as a donor atom. Specific examples of the coordinate group include: as coordinate groups having an oxygen atom as a donor atom, -OH (alcohol, enol and phenol), -COOH (carboxylic acid), >C=O (aldehyde, ketone, quinine), -O- (ether), - COOR (ester; R represents aliphatic or aromatic hydrocarbon), -N=O (nitroso compounds), -NO₂ (nitro compounds), >N-O (N-oxide), -SO₃H (sulfonic acid), - PO₃H₂ (phosphorous acid), etc.; as coordinate groups having a nitrogen atom as a donor atom, -NH₂ (primary amine, amide, hydrazine), >NH (secondary amine, hydrazine), >N- (tertiary amine), -N=N- (azo compounds, heterocyclic compounds), =N-OH (oxime), -NO₂ (nitro compounds), -N=O (nitroso compounds), >C=N-(Schiff base, heterocyclic compounds), >C=NH (aldehyde, ketonimine, enamines), - NCS (isothiocyanato), etc.; and, as coordinate groups having a sulfur atom as a donor atom, -SH (thiol), -S- (thioether), >C=S (thioketone, thioamide), =S- (heterocyclic compounds), -C(=O)-SH or -C(=S)-OH and -C(=S)-SH (thiocarboxylic acid), -SCN (thiocyanate), etc.

Among the above organic complex compounds formed with metals and coordinate groups, examples of organic complex compounds that are preferably used include complex compounds of metals such as Al, Ti, Fe, Mn, Co, Ni, Cu, Zn, Ge, In, Sn, Zr, and Hf with β-diketones, amines, alcohols, and carboxylic acids. Examples of particularly preferable complex compounds include acetylacetone complexes and acetoacetic acid ester complexes of Al, Fe, Ti, and Zr.

Specific examples of such compounds that can be cited herein include, but are not limited to, the following compounds,: aluminium trisacetylacetonate, aluminium tris(ethylacetoacetate), aluminium tris(propylacetoacetate), aluminium tris(butylacetoacetate), aluminium tris(hexylacetoacetate), aluminium tris(nonylacetoacetate), aluminium tris(hexafluoropentadionate), aluminium tris(2,2,6,6-tetramethyl-3,5-heptanedionate), aluminium bisethylacetoacetate monoacetylacetonate, aluminium diacetylacetonate ethylacetoacetate, aluminium monoacetylacetonate bispropylacetoacetate, aluminium monoacetylacetonate bisbutylacetoacetate, aluminium monoacetylacetonate bishexyl-acetoacetate, aluminium monoethylacetoacetate bispropylacetoacetate, aluminium monoethylacetoacetate bisbutylacetoacetate, aluminium monoethylacetoacetate bishexylacetoacetate, aluminium monoethylacetoacetate bisnonylacetoacetate, aluminium dibutoxide monoacetoacetonate, aluminium dipropoxide monoacetoacetonate, aluminium diiso-propoxide ethylacetoacetate, aluminium di-s-butoxide bis(ethylacetoacetate), aluminium di-s-butoxide ethylacetoacetate, aluminium-9-octadecenylacetoacetate diiso-propoxide, titanium allylacetoacetate triiso-propoxide, titanium bis(triethanolamine)diiso-propoxide, titanium bis(triethanolamine) di-n-butoxide, titanium diiso-propoxide bis(2,4-pentanedionate), titanium di-n-butoxide bis(2,4-pentanedionate), titanium diiso-propoxide bis(2,2,6,6-(tetramethyl-3,5-heptane-dionate), titanium diiso-propoxide bis(ethylacetoacetate), titanium di-n-butoxide bis(ethylacetoacetate), titanium ethylacetoacetate tri-n-butoxide, titanium methacryloxyethylacetoacetate triiso-propoxide, titanium oxide bis(2,4-pentanedionate), titanium tetra(2-ethyl-3-hydroxyhexyloxide), dihydroxy bis(lactate)titanium, (ethylene glycolate) titaniumbis(dioctyl phosphate), zirconium di-n-butoxide bis(2,4-pentanedionate), zirconium tetrakis(hexafluoropentanedionate), zirconium tetrakis(trifluoropentanedionate), zirconium methacryloxyethylacetoacetate tri-n-propoxide, zirconium tetrakis(2,4-pentanedionate), zirconium tetrakis(2,2,6,6-tetramethyl-3,5-heptanedionate), triglycolate zirconate, trilactate zirconate, iron (III) acetylacetonate, dibenzoylmethane iron (II), tropolone iron, tristropolono-iron (III), hinokitiol iron, trishinokitiolo-iron (III), acetoacetic acid ester iron (III), iron(III) benzoylacetonate, iron (III) diphenylepropanedionate, ion (III) tetramethylheptanedionate, and iron (III) trifluoropentanedionate

The proportion of the organic complex compound in the heat sensitive layer is preferably from 0.5% to 50% by mass, and more preferably from 3% to 30% by mass of the heat sensitive layer. By setting the amount of the organic complex compound to 0.5% by mass or more, the above effects can be expected. Meanwhile, by setting it to 50% by mass or less, problems such as reduction of printing durability of the printing plate are unlikely to occur.

As a novolac resin is used as an active hydrogen-containing polymer for the heat sensitive layer of the lithographic printing plate original used in the method of producing a printed material of the invention, image reproducibility and water-based ink resistance can be achieved in a well-balanced manner by controlling the mass ratio of novolac resin : organic complex compound in a range of from 2 to 6. In order to achieve highly fine image reproducibility, the mass ratio of novolac resin : organic complex compound is 2 or more, preferably 2.5 or more, and more preferably 3 or more. In addition, the mass ratio of novolac resin : organic complex compound is 6 or less, preferably 5.5 or less, and more preferably 5 or less. This is because the crosslinked structure of the novolak resin is densely formed so that solubility in the water-based ink decreases, which allows the heat sensitive layer to have improved water-based ink resistance, resulting in an increase in the number of printable sheets.

The lithographic printing plate original used in the method of producing a printed material of the invention is preferable in that it contains an urethane resin in the heat sensitive layer so that the surface of the heat sensitive layer can be unevenly formed to an appropriate extent in the exposure step and the development step, resulting in the improvement of inking performance of the water-based ink. Examples of the urethane resin include urethane resins obtained from polyisocyanate and polyalcohol.

Specific examples of polyisocyanate include the following:
paraphenylene diisocyanate, 2,4-toluene diisocyanate, 2,6-toluene diisocyanate, 4,4-diphenylmethanediisocyanate, tolidinediisocyanate, xylylenediisocyanate, hydrogenated xylylenediisocyanate, cyclohexanediisocyanate, meta-xylenediisocyanate, hexamethylene diisocyanate, 2,6-diisocyanatemethylcaproate, 4,4'-methylene bis(cyclohexylisocyanate), methylcyclohexane 2,4(2,6)diisocyanate, 1,3-(isocyanatemethyl)cyclohexane, isophoronediisocyanate, diphenylether isocyanate, trimethylhexamethylene diisocyanate, tetramethylxylene diisocyanate, polymethylene polyphenylisocyanate, dimer acid diisocyanate, triphenylmethane triisocyanate, tris(isocyanatephenyl)thiophosphate, tetramethylxylylenediisocyanate, lysine estertriisocyanate, 1,6,11-undecanetriisocyanate, 1,8-diisocyanate-4-isocyanatemethyloctane, 1,3,6-hexamethylene triisocyanate, bischloroheptane triisocyanate, and 1,5-naphthalenediisocyanate.

Further, modified forms or derivatives of the above polyisocyanates are also preferably used. Examples of such modified forms or derivatives of polyisocyanates include urethane-modified polyisocyanates generated as reaction products of polyisocyanates and alcohols, polyisocyanate dimer (also known as uretidione) or trimer (also known as isocyanurate) generated as a reaction product of two or three polyisocyanates, polycarbodiimide generated via decarbonation, or allophanate-modified, biuret-modified, and urea-modified polyisocyanates generated as reaction products of polyisocyanates, alcohols, amine compounds, etc., and further include blocked isocyanate.

Polyalcohols can be roughly classified into polyetherpolyols, polyesterpolyols, and others.

Specific examples of polyetherpolyols include ethylene glycol, propylene glycol, 1,3-propanediol, 1,4-butanediol, 1,3-butylene glycol, 1,5-pentanediol, 1,6-hexanediol, diethylene glycol, dipropylene glycol, neopenthyl glycol, triethylene glycol, p-xylylene glycol, hydrogenated bisphenol A, bisphenol dihydroxypropylether, glycerin, trimethylolethane, trimethylolpropane, trishydroxymethylaminomethane, pentaerithritol, dipentaerithritol, sorbitol, polypropylene glycol, polyethylene glycol, polytetramethylene glycol, ethyleneoxide-propyleneoxide copolymers, tetrahydrofuran-ethyleneoxide copolymers, tetrahydrofuran-propyleneoxide copolymers, tetrahydrofurancation copolymer, and epoxy resin-modified polyol.

Polyester polyols can be further classified into condensed polyester polyol, lactone polyester polyol, polycarbonate polyol, and the like.

Condensed polyester polyol can be obtained via dehydration condensation between glycol or triol and polycarboxylic acid and its anhydride.

Examples of polycarboxylic acid and polycarboxylic acid anhydride include phthalic anhydride, isophthalic acid, terephthalic acid, succinic anhydride, adipic acid, azelaic acid, sebacic acid, tetrahydrophthalic anhydride, hexahydrophthalic anhydride, tetrabromophthalic anhydride, tetrachloro phthalic anhydride, HET anhydride, himic anhydride, maleic anhydride, fumaric acid, itaconic acid, trimellitic anhydride, methyl cyclohexene tricarboxylic acid anhydride, and pyromellitic anhydride

Specific examples thereof include polyethylene adipate, polypropylene adipate, polyhexamethylene adipate, polyneopenthyl adipate, polyhexamethylene neopenthyl adipate, polyethylenehexamethylene adipate, and polytetramethylene adipate.

Examples of lactone-based polyester polyol include those obtained via ring-opening polymerization of lactones such as β-propiolactone, γ-butyrolactone, δ-valerolactone, and ε-caprolactone.

Furthermore, examples of polyols that can be used include acrylic polyol that is a copolymer of hydroxyl group-containing acrylic (or methacrylic) monomer such as β-hydroxyethyl methacrylate and acrylic (or methacrylic) ester, terminal hydroxyl group-containing butadiene and its copolymer (i.e., polybutadiene polyol), and partially saponified EVA, and further include variety of phosphorus-containing polyols, halogen-containing polyols, and phenol-based polyols. Also, branched urethane resins or urethane resins having various functional groups such as a hydroxyl group can also be used.

Examples of polycarbonate polyols include amorphous polycarbonate polyols obtained via copolymerization of ring-opening polymerization products of ethylene carbonate obtained with the use of, as an initiator, a low-molecular-weight polyol such as ethylene glycol, propylene glycol, 1,3-propanediol, 1,4-butanediol, 1,3-butylene glycol, 1,5-pentanediol, or 1,6-hexanediol and ring-opening polymerization products of ethylene carbonate and dihydric alcohols such as 1,4-butanediol, 1,5-pentanediol, 3-methyl-1,5-pentanediol, and 1,6-hexanediol. Further, among the polycarbonate polyols, polyhexamethylene carbonate diol having 6 or more carbon atoms that form the main chain is more preferable.

The content of urethane resin in the heat sensitive layer is preferably 10% by mass or more of the heat sensitive layer from the viewpoint of the improvement of inking performance of the water-based ink. Meanwhile, in order to maintain sensitivity at increased levels, the content in the heat sensitive layer is preferably 50% by mass or less.

The heat sensitive layer of the lithographic printing plate original used in the method of producing a printed material of the invention can be imparted with water-based ink resistance and inking performance of the water-based ink in a well-balanced manner by precisely controlling the novolac resin/urethane resin mass ratio. In order to further improve water-based ink resistance of the heat sensitive layer, the novolac resin/urethane resin mass ratio is preferably 1.0 or more, more preferably 1.5 or more, and further preferably 2.0 or more. In order to improve inking performance of the water-based ink for the heat sensitive layer, the novolac resin/urethane resin mass ratio is preferably 5.0 or less, more preferably 4.0 or less, and further preferably 3.0 or less.

It is preferable for the heat sensitive layer to contain an active hydrogen-free polymer having a film forming ability as well as a novolac resin. Examples of such polymer include homopolymers or copolymers of (meth)acrylate esters such as polymethyl(meth)acrylate, polybutyl(meth)acrylate, etc., homopolymers or copolymers of styrene-based monomers such as polystyrene, α-methylstyrene, etc., various synthetic rubbers of isoprene, styrene-butadiene, etc., homopolymers of vinyl esters such as polyvinyl acetate, etc., copolymers of vinyl acetate-vinyl chloride, etc., and various condensate polymers of polyester, polycarbonate, etc.

The content of such other polymers is preferably 50% by mass or less, more preferably 30% by mass or less, and further preferably 10% by mass or less with respect to the total solid content of the heat sensitive layer.

In addition, various additives may be added to the heat sensitive layer as necessary. In order to improve application performance, a silicone-based surfactant, a fluorine-based surfactant, or the like can be added. In order to enhance the adhesion between the heat sensitive layer and the silicone rubber layer, a silane coupling agent, a titanium coupling agent, or the like may also be added. The content of these additives may differ depending on intended use; however, it is usually from 0.1% to 30% by mass with respect to the total solid content of the heat sensitive layer.

The average thickness of the heat sensitive layer is preferably 0.3 µm or more and more preferably 0.8 µm or more. Meanwhile, it is preferably 10 µm or less and more preferably 7 µm or less. The average thickness of the heat sensitive layer is set to 0.3 µm or more so that developability is unlikely to be reduced. It is also set to 10 µm or less so that there should be no economical disadvantages.

The lithographic printing plate original used in the method of producing a printed material of the invention has an ink repelling layer that repels a water-based ink so as to form non-imaging areas.

It is preferable for the ink repelling layer to have hydrophobicity in order to repel a water-based ink. The term "hydrophobicity" used herein means a water contact angle of 60° or more. It is therefore preferable that the ink repelling layer contains a hydrophobic substance. Specific examples thereof include silicone rubbers, fluorine resins, polyester resins, styrene-butadiene rubbers, nylon resins, nitrile rubbers, polyvinyl acetate, urethane resins, ethylene-vinyl acetate copolymers, polybutadiene, polyisoprene, polypropylene, and polyethylene. It is particularly preferable to use a silicone rubber.

Such silicone rubber can be obtained via crosslinking of organopolysiloxane. Crosslinking may be carried out via an addition reaction or a condensation reaction.

An addition reaction-type silicone rubber is formed with a composition (hereinafter referred to as "silicone liquid") containing at least vinyl-group containing organopolysiloxane, an SiH-group containing compound, a curing catalyst, and if necessary, a reaction inhibitor and a solvent.

The vinyl group-containing organopolysiloxane has a structure represented by the following general formula (I), and has a vinyl group at the main-chain end or in the main chain. A vinyl group-containing organopolysiloxane, which has a vinyl group at the main-chain end, is particularly preferable.

### [Chem. 1]

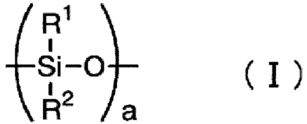

In general formula (I), a represents an integer of 2 or more. R¹ and R² each represent a saturated or unsaturated hydrocarbon group with 1 to 50 carbon atoms. A hydrocarbon group may have a linear-chain, branched, or cyclic structure, or may have an aromatic ring. R¹ and R² may be the same or different. A plurality of R¹ present in polysiloxane of general formula (I) may be the same or different. In addition, a plurality of R² present in polysiloxane of general formula (I) may be the same or different. Specific examples of a saturated or unsaturated hydrocarbon group with 1 to 50 carbon atoms include a methyl group, an ethyl group, an n-propyl group, a phenyl group, and a vinyl group.

As for R¹ and R², it is preferable that at least 50% of all be methyl groups, in view of ink repellency of the lithographic printing plate. In addition, the weight average molecular weight of vinyl group-containing organopolysiloxane is preferably 10,000 to 600,000 in view of handling convenience and ink repellency or scratch resistance of the lithographic printing plate. The weight average molecular weight of the vinyl group-containing organopolysiloxane of the invention represents a polystyrene-reduced value measured by the gel permeation chromatography (GPC) method using polystyrene as a standard substance.

Examples of the SiH group-containing compound include organohydrogen polysiloxane and organic polymers having a diorganohydrogensilyl group. Organohydrogen polysiloxane is preferable. Organohydrogen siloxane may have a linear-chain, cyclic, branched, or web molecular structure. Specific examples thereof include the following: polymethylhydrogensiloxanes sealed with trimethylsiloxy groups at the molecular chain ends, dimethylsiloxane/methylhydrogensiloxane copolymers sealed with trimethylsiloxy groups at the molecular chain ends, dimethylsiloxane/methylhydrogensiloxane/methylphenylsiloxane copolymers sealed with trimethylsiloxy groups at the molecular chain ends, dimethylpolysiloxanes sealed with dimethylhydrogensiloxy groups at the molecular chain ends, dimethylsiloxane/methylphenylsiloxane copolymers sealed with dimethylhydrogensiloxy groups at the molecular chain ends, and methylphenylpolysiloxanes sealed with dimethylhydrogensiloxy groups at the molecular chain ends; and an organopolysiloxane copolymer comprising a siloxane unit represented by R₃SiO_{1/2}, a siloxane unit represented by R₂HSiO_{1/2}, and a siloxane unit represented by SiO_{4/2}; an organopolysiloxane copolymer comprising a siloxane unit represented by R₂HSiO_{1/2} and a siloxane unit represented by SiO_{4/2}; and an organopolysiloxane copolymer comprising a siloxane unit represented by RHSiO_{2/2}, a siloxane unit represented by RSiO_{3/2}, and a siloxane unit represented by HSiO_{3/2}.

These two or more examples of organopolysiloxane may be used. In the above composition formula, R represents a monovalent hydrocarbon other than an alkenyl group. Examples thereof include: alkyl groups such as a methyl group, an ethyl group, a propyl group, a butyl group, a pentyl group, a hexyl group, and a heptyl group; aryl groups such as a phenyl group, a tolyl group, a xylyl group, and a naphtyl group; aralkyl groups such as a benzil group and a phenetyl group; alkyl halide groups such as a chloromethyl group, 3-chloropropyl group, and 3,3,3-trifluoropropyl group.

Examples of organic polymers having a diorganohydrogensilyl group include the following: oligomers formed via polymerization of: dimethylhydrogensilyl group-containing acrylic monomers of dimethylhydrogensilyl methacrylate, dimethylhydrogensilylpropyl(meth)acrylate, etc.; and monomers of methyl(meth)acrylate, ethyl(meth)acrylate, butyl(meth)acrylate, ethylhexyl(meth)acrylate, lauryl(meth)acrylate, styrene, α-methylstyrene, maleic acid, vinyl acetate, allyl acetate, etc.

The content of an SiH-group-containing compound is preferably 0.5% by mass or more and more preferably 1% by mass or more with respect to the non-solvent components of a silicone liquid in terms of curability of the ink repelling layer. In addition, it is preferably 20% by mass or less and more preferably 15% by mass or less.

Examples of the reaction inhibitors include nitrogen-containing compounds, phosphorus-based compounds, unsaturated alcohols, etc. Acetylene-containing alcohols and the like are preferably used. It is possible to adjust the rate of curing of the ink repelling layer by adding such reaction inhibitors. The content of the reaction inhibitor is preferably 0.01% by mass or more and more preferably 0.1% by mass or more with respect to the non-solvent components of a silicone liquid in terms of stability of silicone liquid. In addition, it is preferably 20% by mass or less and more preferably 15% by mass or less with respect to the non-solvent components of a silicone liquid in terms of curability of the ink repelling layer.

A curing catalyst is selected from known curing catalysts; however, it is preferably a platinum-based compound. Specific examples thereof include platinum, platinum chloride, chloroplatinic acid, olefin coordinated platinum, alcohol modified complex of platinum, methylvinyl polysiloxane complex of platinum, etc. The content of the curing catalyst is preferably 0.001% by mass or more and more preferably 0.01% by mass or more with respect to the non-solvent components of a silicone liquid in terms of curability of the ink repelling layer. In addition, it is preferably 20% by mass or less and more preferably 15% by mass or less with respect to the non-solvent components of a silicone liquid in terms of stability of the silicone liquid.

In addition to the aforementioned compounds, the ink repellent layer may also contain a hydroxyl group-containing organopolysiloxane or hydrolyzable functional group-containing silane (or siloxane), and a known filler such as silica or the like for the purpose of improving the rubber strength or a known silane coupling agent for the purpose of improving adhesiveness. Preferable examples of silane coupling agents include alkoxysilanes, acetoxysilanes, and ketoximine silanes. Particularly, a silane coupling agent having a vinyl group or an allyl group is preferable.

A condensation reaction-type ink repelling layer contains at least a hydroxyl group-containing organopolysiloxane, a cross-linking agent, and a curing catalyst as necessary, as well as compositions comprising a solvent (silicone liquid). The hydroxyl group-containing organopolysiloxane has a structure represented by general formula (II), and has a hydroxyl group at the main chain end or within the main chain. A hydroxyl group-containing organopolysiloxane, which has a hydroxyl group at the main-chain end, is particularly preferable.

### [Chem 2]

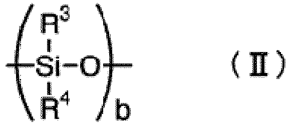

(where b represents an integer of 2 or more, R³ and R⁴ may be the same or different and each represent a saturated or unsaturated hydrocarbon group with 1 to 50 carbon atoms.) A plurality of R³ present in polysiloxane of general formula (II) may be the same or different. In addition, a plurality of R⁴ present in polysiloxane of general formula (I) may be the same or different. A hydrocarbon group may have a linear-chain, branched, or cyclic structure, or may have an aromatic ring. Here, specific examples of a saturated or unsaturated hydrocarbon group with 1 to 50 carbon atoms include the examples for R¹ and R².

As for R³ and R⁴ in general formula (II), it is preferable that at least 50% of all be methyl groups in view of ink repellency of the printing plate. The weight average molecular weight of hydroxyl group-containing organopolysiloxane is preferably 10,000 to 600,000 in view of handling convenience and ink repellency or scratch resistance of the lithographic printing plate. The weight average molecular weight of the hydroxyl group-containing organopolysiloxane of the invention represents a polystyrene-reduced value measured by the gel permeation chromatography (GPC) method using polystyrene as a standard substance.

Examples of the crosslinker usable in the condensation reaction-type ink repelling layer include acetoxysilanes, alkoxysilanes, ketoximine silanes, and allyloxysilanes.

Specific examples thereof include: acetoxy silanes such as methyltriacetoxysilane, ethyltriacetoxysilane, vinyltriacetoxysilane, allyltriacetoxysilane, phenyltriacetoxysilane, and tetraacetoxysilane; ketoxime silanes such as vinylmethylbis(methylethylketoximine)silane, methyltris(methylethylketomixine)silane, ethyltris(methylethylketomixine)silane, vinyltri(methylethylketoximine)silane, allyltris(methylethylketomixine)silane, phenyltris(methylethylketomixine)silane, and tetrakis(methylethylketomixine)silane; alkoxy silanes such as methyltrimethoxysilane, methyltriethoxysilane, ethyltrimethoxysilane, ethyltriethoxysilane, tetraethoxysilane, tetrapropoxysilane, vinyltrimethoxysilane, vinyltriethoxysilane allyltriethoxysilane, and vinyltriisopropoxysilane; alkenyloxy silanes such as vinyltrisisopropenoxysilane, diisopropenoxydimethylsilane, and triisopropenoxymethylsilane; and tetraallyloxysilane, etc. However, the listed compounds are not restrictive. Among the compounds, acetoxy silanes or ketoximine silanes are preferable in view of the curing rate of the ink repellent layer, handling convenience, etc.

The content of a crosslinker is preferably 0.5% by mass or more and more preferably 1% by mass or more with respect to the non-solvent components of a silicone liquid in terms of stability of the silicone liquid. In addition, it is preferably 20% by mass or less and more preferably 15% by mass or less with respect to the non-solvent components of a silicone liquid in view of strength of the ink repelling layer or scratch resistance of the printing plate.

Examples of the curing catalyst include acids such as organic carboxylic acids including acetic acid, propionic acid, maleic acid, etc., toluenesulfonic acid, boric acid, etc., alkalis such as potassium hydroxide, sodium hydroxide, lithium hydroxide, etc., amines, metal alkoxides such as titanium tetrapropoxide, titanium tetrabutoxide, etc., metal diketenates such as iron acetylacetonate, titanium acetylacetonate dipropoxide, etc., organic acid salts of metals, etc. Of these, an organic acid salt of a metal is preferable, and an organic acid salt of a metal selected from tin, lead, zinc, iron, cobalt, calcium and manganese is particularly preferable. Specific examples of such compounds include dibutyltin diacetate, dibutyltin dioctate, dibutyltin dilaurate, zinc octylate, iron octylate, etc. The content of the curing catalyst is preferably 0.001% by mass or more and more preferably 0.01% by mass or more with respect to the non-solvent components of a silicone liquid in terms of curability and adhesiveness of the ink repelling layer. In addition, it is preferably 15% by mass or less and more preferably 10% by mass or less with respect to the non-solvent components of a silicone liquid in terms of stability of the silicone liquid.

In addition to the foregoing components, the ink repellent layer may contain a known filler for improving the rubber strength, and may further contain a known silane coupling agent.

In addition, it is preferable for the lithographic printing plate original used in the method of producing a printed material of the invention to contain a liquid having a boiling point of 150°C or more at 1 atmospheric pressure in the ink repelling layer in view of the improvement of ink repellency. When the plate surface is pressurized during printing, the ink repelling liquid comes out to the surface of the ink repelling layer, which facilitates ink to fall off. Thus, ink repellency is improved. Here, the ink repelling liquid is preferably a liquid that prevents an ink to adhere to the ink repelling layer when the liquid is present on the surface of the ink repelling layer in a state of lacking the liquid. It is considered that the ink repelling liquid prevents the adhesion to the ink repelling layer by forming a thin liquid film covering the surface of the ink repelling layer. When the boiling point is 150°C or more, the ink repelling layer is unlikely to volatilize so that the ink repelling effects obtained with the addition of this liquid should not be lost. The boiling point mentioned herein is defined as a temperature at which a decrease in mass after static placement for 1 hour in an environment at 1 atmospheric pressure is 0.5% by mass or more. In addition, by allowing the ink repelling layer to contain a liquid that is less compatible with a water-based ink, it is possible to achieve ink repellency without increasing the film thickness. In other words, the liquid has a decrease in mass after static placement for 1 hour in an environment at 150°C and 1 atmospheric pressure, which is less than 0.5% by mass. If this is the case, the ink repelling effects obtained with the addition of this liquid will not be lost. The ink repelling layer of a lithographic printing plate prepared via the aforementioned steps of exposure and development of the lithographic printing plate original also contains a liquid having a boiling point of 150°C or more at 1 atmospheric pressure. In other words, the ink repelling layer of the lithographic printing plate also contains the liquid having a decrease in mass after static placement for 1 hour in an environment at 150°C and 1 atmospheric pressure, which is less than 0.5% by mass.

Examples of the liquid having a boiling point of 150°C or more include hydrocarbon-based solvents, silicone-based liquids, fluorocarbon solvents, unsaturated fatty acid esters, alkyl fatty acid esters, alkyl acrylate, alkyl methacrylate, and alchohols having 6 or more carbon atoms. Specific examples of the liquid having a boiling point of 150°C or more include, but are not limited to, the following:
naphthenic oil, paraffin oil, 1,1,1,2,2-pentafluoro ethane, 1,1,1,2,2,3,3,4,4 nonafluorobutane, 1,1,1,2, 2,3,3,4,4,5,5,6,6-tridecafluorohexane, 1,1,1,2,2,3,3,4,4,5,5,6,6,7,7,8,8- heptadecafluorooctane, 1,1,1,2,3,3,3-heptafluoropropane, 1,1,1,2,3,3,4,4-octafluoro-2-trifluoromethyl butane, 1,1,1,2,3,3,4,4,5,5,6,6- dodecafluoro-2-trifluoromethylhexane, 1,1,2,2-tetrafluoroethane, 1,1,2,2,3,3,4,4- octafluorobutane, 1,1,2,2,3,3,4,4,5,5,6,6-dodecafluorohexane, ethyl caproate, ethyl caprylate, cetyl caprylate, octadecyl caprylate, ethyl caprate, isopropyl laurate, hexyl laurate, dodecyl laurate, isostearyl laurate, cetyl laurate, isocetyl laurate, butyl myristate, isopropyl myristate, decyl myristate, isotridecyl myristate, tetradecyl myristate, cetyl myristate, isocetyl myristate, isostearyl myristate, octyldodecyl myristate, ethyl palmitate, isopropyl palmitate, octyl palmitate, dodecyl palmitate, ethylhexyl palmitate, cetyl palmitate, hexyldecyl palmitate, octadecyl palmitate, isostearyl palmitate, ethyl stearate, isopropyl stearate, butyl stearate, isobutyl stearate, octyl stearate, ethylhexyl stearate, tridecyl stearate, cetyl stearate, isocetyl stearate, cetearyl stearate, octadecyl stearate, octyldodecyl stearate, ethyl isostearate, hexyl isostearate, tridecyl isostearate, isostearyl isostearate, octyldodecyl isostearate, methyl oleate, ethyl oleate, octyl oleate, dodecyl oleate, isododecyl oleate, oleyl oleate, octyldodecyl oleate, ethyl linoleate, isopropyl linoleate, oleyl linoleate, ethyl linoleate, coconut oil fatty acid ethyl, nonyl acrylate, decyl acrylate, undecyl acrylate, dodecyl acrylate, tridecyl acrylate, tetradecyl acrylate, pentadecyl acrylate, hexadecyl acrylate, nonyl methacrylate, decyl methacrylate, undecyl methacrylate, dodecyl methacrylate, tridecyl methacrylate, tetradecyl methacrylate, pentadecyl methacrylate, hexadecyl methacrylate, 1-hexanol, 1-heptanol, 1-octanol, and 1-nonanol. Of these, a hydrocarbon-based solvent or silicone-based liquid having strong ink repelling effects is particularly preferable.

The term "silicone-based liquid" used in the invention refers to the organosiloxane component in the liquid form which is not involved in a reaction of forming an ink repelling layer. Specific examples thereof include non-reactive silicone-based liquids such as dimethyl silicone, methylphenyl silicone, alkyl-modified silicone, polyether-modified silicone, aralkyl-modified silicone, fatty acid amide-modified silicone, fatty acid ester-modified silicone, and fluoroalkyl-modified silicone. It is also possible to use a silicone-based liquid having a reactive functional group unless it is involved in a reaction of forming an ink repelling layer. Examples thereof include methyl hydrogen silicone, silanol-modified silicone, alcohol-modified silicone, amino-modified silicone, epoxy-modified silicone, epoxy-polyether-modified silicone, phenol-modified silicone, carboxy-modified silicone, and mercapto-modified silicone.

These liquid having a boiling point of 150°C or more can each be used on their own or they can be used in the form of mixtures of two or more types.

The content of the ink repelling liquid in the ink repelling layer is preferably 10% by mass or more so that the ink repelling liquid is allowed to sufficiently come out to the surface of the ink repelling layer, thereby remarkably improving ink repellency. In addition, in order to maintain the film strength of the ink repelling layer, the content of the ink repelling liquid in the ink repelling layer is preferably 50% by mass or less, more preferably 40% by mass or less, and further preferably 30% by mass or less.

The film thickness of the ink repelling layer is preferably 0.5 to 20 g/m², and more preferably 0.5 to 5 g/m². If the film thickness is less than 0.5 g/m² the ink repellency of the printing plate tends to be reduced, while in the case of more than 20 g/m², not only is this disadvantageous from an economic standpoint but also there is the problem that the ink mileage deteriorates.

For the lithographic printing plate original, in order to improve adhesiveness between the base material and the ink repelling layer or between the base material and the heat sensitive layer, prevent light halation, and improve plate inspectability, heat insulating properties, and printing durability, a heat-insulating layer may be disposed in the base material. An example of the heat-insulating layer used in the invention is a heat-insulating layer containing a polyurethane resin, an organic complex compound, and titanium oxide particles disclosed in Japanese Patent Application Laid-Open Publication No. 2006-276385, etc.

In addition, the lithographic printing plate original may have a protective film and/or interleaving paper for the purpose of protecting the ink repelling layer.

As the protective film, a film having a thickness of 100 µm or less, at which light with a wavelength of an exposure light source sufficiently permeates the film, is preferable. Typical examples of materials for the protective film include polyethylene, polypropylene, polyvinyl chloride, polyethylene terephthalate, and cellophane. In addition, various light-absorbing agents, photochromic substances, and photobleaching substances disclosed in JP Patent No. 2938886 may be present on the protective film for the purpose of preventing sensitization of the plate original due to light exposure.

As the interleaving paper, an interleaving paper having a weight per square meter of 30 to 120 g/m² is preferable, and an interleaving paper having a weight per square meter of 30 to 90 g/m² is more preferable. When the weight per square meter is 30 g/m² or more, sufficient mechanical strength is achieved. When it is 120 g/m² or less, it is economically advantageous, and it is also advantageous in terms of workability because a layered product of the lithographic printing plate original and a paper can be thinned. Examples of interleaving paper that can be preferably used include, but are not limited to, printing media (40 g/m²; Nagoya Pulp Corporation), metal interleaving paper (30 g/m²; Nagoya Pulp Corporation), unbleached kraft paper (50 g/m²; Chuetsu Pulp & Paper Co., Ltd.), NIP paper (52 g/m² Chuetsu Pulp & Paper Co., Ltd.) pure white rolled paper (45 g/m²; Oji Paper Co., Ltd.), Clupack paper (73 g/m²; Oji Paper Co., Ltd.).

The method of producing a lithographic printing plate original may include at least a step of forming a heat sensitive layer on a base material in such order and a step of further forming an ink repelling layer. The method may further include other steps. For example, it is possible to coat a base material that may have a heat-insulating layer with a heat sensitive layer composition or a heat sensitive layer composition liquid and, if necessary, dry the coating, thereby forming a heat sensitive layer. It is also possible to coat a heat sensitive layer with an ink repelling layer composition or an ink repelling layer composition liquid prepared by adding a solvent to an ink repelling layer composition and, if necessary, dry the coating, thereby forming an ink repelling layer.

Examples of the apparatus used for coating include a slit die coater, a direct gravure coater, an offset gravure coater, a reverse roll coater, a natural roll coater, an air knife coater, a roll blade coater, a burr bar roll blade coater, a two-stream coater, a rod coater, a dip coater, a curtain coater, and a spin coater. In terms of the coating accuracy, productivity, and cost, a slit die coater, a gravure coater, and roll coater are particularly preferable.

Thereafter, where required, a protective film is laminated or a protective layer formed. Then, a lithographic printing plate original is irradiated with laser so as to apply physical stimulations. This causes a part of the ink repelling layer to be removed so that an ink repelling layer and an ink-accepting heat sensitive layer are present on the surface of the plate original.

The method of producing a lithographic printing plate is specifically described below. The method is not particularly limited. However, a method which comprises a step of irradiating a lithographic printing plate original having at least an ink repelling layer and a heat sensitive layer with laser (hereinafter referred to as "exposure step") is preferably employed. It is possible to prepare the lithographic printing plate of the invention by the exposure step alone. However, the method further preferably comprises a step of applying physical stimulations to the exposed lithographic printing plate original for development (hereinafter referred to as "development step"). By applying physical stimulations to the exposed lithographic printing plate original, the surface of the heat sensitive layer can be unevenly formed, resulting in the improvement of inking performance of the water-based ink on the heat sensitive layer, which is preferable.

As the laser light source employed in the plate processing light-exposure stage, one with an oscillation wavelength region in the range 300 nm to 1500 nm is preferably employed. Specifically, various lasers can be used such as an argon ion, krypton ion, helium-neon, helium-cadmium, ruby, glass, YAG, titanium sapphire, dye, nitrogen, metal vapor, excimer, free-electron, or semiconductor laser.

Of these, for the purpose of processing the lithographic printing plate original of the invention, a semiconductor laser of emission wavelength region in the vicinity of the near infrared region is preferred, with the use of a high output semiconductor laser being particularly preferred.

It is preferable to remove the ink repelling layer in the exposed regions of the lithographic printing plate original after exposure by applying physical stimulations in the presence or water, a liquid prepared by adding a surfactant to water, or an organic solvent. It is also possible to apply physical stimulations in the absence of such liquid. Physical stimulations can be applied by friction using a brush or pad, ultrasound irradiation, spraying, or the like. Specific examples of a method for applying physical stimulations include: (i) a method wherein the plate surface is pretreated with a developer and then rubbed with a rotary brush during showering with tap water; (ii) a method wherein the plate surface is wiped off with nonwoven fabric, absorbent cotton, cloth, sponge, or the like impregnated with a developer; and (iii) a method wherein high-pressure water, warm water, or steam is injected to the plate surface.

Prior to development, it is possible to immerse the plate original in a pre-treatment liquid for a certain period of time for pre-treatment. As the pre-treatment liquid, it is possible to use water, a liquid obtained by adding a polar solvent, such as alcohol, ketone, ester, carboxylic acid, etc., into water, a liquid obtained by adding a polar solvent into a solvent made up of at least one species selected from aliphatic hydrocarbons, aromatic hydrocarbons, etc., or a polar solvent. Furthermore, there can be carried out the addition of surfactants to the aforesaid developer liquid composition. It is preferable for the surfactant to have pH 5 to 8 in the form of aqueous solution in view of safety, disposal cost, etc. The content of the surfactant in the developer is preferably 0.1% by mass or more in view of wettability on the lithographic printing plate original, it is preferably 10% by mass or less in view of permeability into the lithographic printing plate original. Such developer is highly safe and preferable from the economic viewpoint in terms of disposal cost, etc. It is preferable that a glycol compound or a glycol ether compound be used as a major component. It is more preferable that an amine compound coexist.

Examples of the pre-treatment liquid and the developer include water, alcohol, and paraffin-based hydrocarbons. In addition, it is also possible to use a mixture of water and propylene glycol, dipropylene glycol, triethylene glycol, polypropylene glycol, or a propylene glycol derivative such as an alkylene oxide adduct of polypropylene glycol. Specific examples of the developer include HP-7N and WH-3 (each produced by Toray Industries, Inc.). As the pre-treatment liquid, for example, a pre-treatment liquid containing a diamine compound having polyethylene ether diol and two or more primary amino groups disclosed in JP Patent No. 4839987 can be used. Specific examples of the pre-treatment liquid include PP-1, PP-3, PP-F, PP-FII, PTS-1, PH-7N, CP-1, NP-1, and DP-1 (each produced by Toray Industries, Inc.).

Again, in order to increase visibility of imaging areas of the printing plate and measurement precision of halftone dots, it is also possible to add to such developers known basic dyes such as Crystal Violet, Victoria Pure Blue or Astrazon Red, so as to carry out dyeing of the heat sensitive layer formed as an ink accepting layer at the same time as the development. Further, it is also possible to perform dyeing using a liquid, to which the above dye has been added, after development.

A part of or all of the above development step can be conducted automatically by an automatic processor. As an automatic processor, the following systems can be used: a system consisting of a development part, a system in which a pre-processing part and a development part are installed in that order, a system in which a pre-processing part, a development part, and a post-processing part are installed in that order, a system in which a pre-processing part, a development part, a post-processing part, and a water washing part are installed in that order, etc. Specific examples of such automatic processor include TWL-650 series, TWL-860 series, TWL-1160 series (each produced by Toray Industries, Inc.) and an automatic processor disclosed in Japanese Patent Application Laid-Open Publication No. HEI5-6000, in which a stand has a curved recess in order to prevent scratching. These examples may be used in combination.

Next, the water-based ink used for the method of producing a printed material of the invention is preferably those that exhibit solubility or dispersibility in water. In order to achieve ink properties required for lithographic printing, it is preferable for the water-based ink to contain at least a pigment, a water-soluble resin, and a diluent. Alternatively, the water-based ink may contain water as the diluent.

The pigment is not particularly limited. An inorganic or organic pigment generally used in lithographic printing inks can be used.

Specific examples of the inorganic pigment include titanium dioxide, calcium carbonate, barium sulfate, red iron oxide, organic bentonite, alumina white, iron oxide, and carbon black. Examples of the organic pigment include phthalocyanine pigments, soluble azo pigments, insoluble azo pigments, quinacridone pigments, and isoindoline pigments.

Examples of the organic pigment include phthalocyanine pigments, soluble azo pigments, insoluble azo pigments, lake pigments, quinacridone pigments, isoindoline pigments, threne pigments, and metal complex pigments. Specific examples thereof include phthalocyanine blue, phthalocyanine green, azo red, monoazo red, monoazo yellow, disazo red, disazo yellow, quinacridone red, quinacridone magenta, and isoindoline yellow. These pigments can each be used on their own or they can be used in the form of mixtures of two or more types.

The content of the pigment is preferably 5% by mass or more and more preferably 10% or more so that a desirable printing density can be obtained and there is no excess in the amount of ink supplied. Further, it is preferably 40% by mass or less, more preferably 30% by mass or less, still more preferably 25% by mass or less so that fluidity required for lithographic printing is achieved.

The water-soluble resin imparts the water-based ink with viscosity properties suitable for lithographic printing. In addition, it interacts with the pigment in the ink so that the pigment is dispersed. Further, it forms a strong film on the printed material.

Specific examples of such water-soluble resin include acrylic resins, maleic acid resins, polyester resins, and polyurethanes resins. However, the water-soluble resin is not particularly limited as long as it is a resin exhibiting water solubility or water dispersibility. Commercially available resins can also be suitably used. In terms of pigment dispersibility and ink storage stability, acrylic resins and maleic acid resins are preferable.

The acrylic resin are resins obtained by addition polymerization of one or more monomers selected from acrylic acid, methacrylic acid, acrylic acid ester, and methacrylic acid ester and resins obtained by copolymerizing such monomers with one or more unsaturated group-containing compounds. Examples of the monomers include (meth)acrylic acid alkyl ester monomers such as methyl(meth) acrylate, ethyl(meth) acrylate, propyl(meth) acrylate, butyl(meth) acrylate, hexyl(meth) acrylate, 2-ethylhexyl(meth) acrylate, lauryl(meth) acrylate, stearyl(meth) acrylate, 2-hydroxyethyl(meth)acrylate, 2-hydroxypropyl(meth) acrylate, 3-hydroxypropyl(meth) acrylate, methyl carbitol(meth) acrylate, ethyl carbitol(meth) acrylate, butyl carbitol(meth) acrylate, benzyl(meth) acrylate, and naphthyl(meth) acrylate. Examples of the unsaturated group-containing compounds include maleic acid dialkyl esters such as dimethyl maleate, diethyl maleate, and dibutyl maleate, styrene, α-methyl styrene, vinyl toluene, and derivatives thereof. Specific examples thereof include styrene-acrylic acid copolymers, styrene-methyl acrylate- acrylic acid copolymers, styrene-butyl acrylate-acrylic acid copolymers, styrene-methyl methacrylate-acrylic acid copolymers, and styrene-butyl methacrylate-acrylic acid copolymers.

The maleic acid resins are resins obtained by addition polymerization of one or more monomers selected from maleic anhydride and maleic anhydride partially modified with a hydroxyl group-containing compound or an amino group-containing compound and resins obtained by copolymerizing such monomers with one or more types of unsaturated group-containing monomers. Examples of maleic acid-based monomers include maleic acid mono alkyl esters such as maleic acid, maleic anhydride, monomethyl maleate, monoethyl maleate, monopropyl maleate, monobutyl maleate, monohexyl maleate, mono-octyl maleate, mono-2-ethylhexyl maleate, monolauryl maleate, and monostearyl maleate. Examples of the unsaturated group-containing compounds include maleic acid dialkyl esters such as dimethyl maleate, diethyl maleate, and dibutyl maleate, styrene, α-methyl styrene, vinyl toluene, and derivatives thereof. Specific examples include styrene-maleic acid copolymers, styrene-methyl acrylate-maleic acid copolymers, styrene-butyl acrylate-maleic acid copolymers, styrene-methyl methacrylate-maleic acid copolymers, and styrene-butyl methacrylate-maleic acid copolymers.

These water-soluble resins can each be used on their own or they can be used in the form of mixtures of two or more types.

The content of the water-soluble resin in the water-based ink is preferably 5% or mass or more, more preferably 10% by mass or more, and further preferably 15% by mass or more so that the viscosity suitable for lithographic printing can be obtained. In addition, it is preferably 35% by mass or less, more preferably 30% by mass or less, and further preferably 25% by mass or less so that the water-based ink has fluidity and thus can be transferred between rollers.

Any diluent may be used as long as it can dissolve the other components in the water-based ink. Further, the diluent may be cured by polymerization after printing via hot air drying, natural drying, oxidative polymerization, or active energy ray irradiation. Examples of such diluent include water, water-soluble solvents, and water-soluble acrylic monomers. Of these, water-soluble acrylic monomers are preferably used. This is because since water-soluble acrylic monomers are monomers containing an ethylenically unsaturated group, they are cured by polymerization via active energy ray irradiation so that a cured ink film having good water resistance and strength can be obtained. Further, in the case of the heat-sensitive layer having an active hydrogen polymer, water-soluble acrylic monomers are also characterized in that they are unlikely to erode the heat-sensitive layer.

Specific examples of the water-soluble solvent include alcohols, amides, ketones, polyalcohols, and alkyl ethers of polyalcohols.

Examples of alcohols include methanol, ethanol, n- propanol, isopropanol, n-butanol, iso- butanol, and tert-butanol. Examples of amides include dimethylformamide and dimethylacetamide. Examples of ketones include acetone and methyl ethyl ketone. Examples of polyalcohols include ethylene glycol, diethylene glycol, triethylene glycol, tetraethylene glycol, propylene glycol, dipropylene glycol, tripropylene glycol, butylene glycol, and glycerin. Examples of alkyl ethers of polyalcohols include methyl, ethyl, propyl, isopropyl, butyl, isobutyl, tert-butyl, and 2-ethylhexyl of polyalcohols. Other examples are N- methylpyrrolidone, 1,3-dimethyl-2-imidazolidinone, and the like.

In particular, polyalcohols and alkyl ethers of polyalcohols are preferable because they have a boiling point of 150°C or more and thus can prevent drying on the press and improve on-machine stability. These water-soluble solvents can each be used on their own or they can be used in the form of mixtures of two or more types. They may be mixed with water when used.

Any water-soluble acrylic monomer can be used as long as it is a monomer having an ethylenically unsaturated group which has a solubility of 1 g / 100 g or more in water at 25°C and is compatible with a water-soluble resin. Preferable examples thereof include, but are not limited to, ethylene glycol mono(meth)acrylate, diethylene glycol mono(meth)acrylate, triethylene glycol mono(meth)acrylate, polyethylene glycol mono(meth)acrylate, tripropylene glycol mono(meth)acrylate, 1,3-butylene glycol mono(meth)acrylate, 1,6-hexanediol mono(meth)acrylate, 1,9-nonanediol mono(meth)acrylate, neopentyl glycol mono(meth)acrylate, ethylene glycol di(meth)acrylate, diethylene glycol di(meth)acrylate, triethylene glycol di(meth)acrylate, polyethylene glycol di(meth)acrylate, tripropylene glycol di(meth)acrylate, 1,3-butylene glycol di(meth)acrylate, 1, 6-hexanediol di(meth)acrylate, 1,9-nonanediol di(meth)acrylate, neopentyl glycol di(meth)acrylate, glycerin di(meth)acrylate, trimethylolpropane di(meth)acrylate, ethylene oxide-modified glycerine tri(meth)acrylate, ethylene oxide-modified trimethylolpropane tri(meth)acrylate, ethylene oxide modified pentaerythritol tetra(meth)acrylate, pentaerythritol tri(meth)acrylate, and dipentaerythritol penta(meth)acrylate .

These water-soluble acrylic monomers can each be used on their own or they can be used in the form of mixtures of two or more types.

The content of the diluent contained in the water-based ink is preferably 10% by mass or more, more preferably 15% by mass or more, an further preferably 20% by mass or more so as to allow the ink to have appropriate fluidity. Further it is preferably 90% by mass or less, more preferably 80% or less, and further preferably 70% by mass or less so that fluidity required for lithographic printing is achieved. Here, the content of water that can be used as a diluent is preferably from 5% to 80% by weight, more preferably from 10% to 70% by weight, and further preferably from 15% to 60% by weight in order to prevent drying on the press and achieve on-machine stability.

As the active energy ray that is necessary for water-soluble acrylic monomers to be cured, any active energy ray can be used as long as it has an excitation energy required for curing reaction; however, for example, ultraviolet ray and an electron beam can be preferably used. When curing is conducted by an electron beam, an electron beam apparatus with an energy ray of 100 to 500 eV is preferably used. When curing is conducted by UV ray, ultraviolet irradiation apparatuses such as a high-pressure mercury lamp, a xenon lamp, a metal halide lamp, and an LED are preferably used. For example, when using a metal halide lamp, it is preferable to conduct curing using a lamp having an illuminance of 80 to 150W/cm at a conveyor delivery speed of 50 to 150 m/min in view of productivity.

Furthermore, in order to improve sensitivity of the water-based ink to an active energy ray, the water-based ink may contain a photopolymerization initiator and a sensitizer that assists the effect of the photoinitiator. In order to improve storage stability, the water-based ink may contain a polymerization inhibitor or the like.

Further, it is preferable for the water-based ink to contain one or more members selected from hydrocarbon, fluorocarbon, alkyl acrylate, and alkyl methacrylate. These components are hereinafter referred to as "ink repellency-imparting components."

Ink repellency-imparting components have the effect of reducing the adhesion of an ink to the ink repelling layer of the waterless lithographic printing plate. The reason for reducing adhesiveness is presumed as follows. Specifically, ink repellency-imparting components are not compatible with other components contained in the ink so that they disperse from the ink when coming into contact with the plate surface so as to form a thin film that covers the silicone rubber surface. It is assumed that such thin film formed in the above manner can block the adhesion of the ink, thereby preventing scumming

Specific examples of ink-repelling components include, as hydrocarbons, polyolefin oil, naphthenic oil, and paraffin oil.

Examples thereof include, as fluorocarbons, 1,1,1,2,2-pentafluoro ethane, 1,1,1,2,2,3,3,4,4 nonafluorobutane, 1,1,1,2,2, 3,3,4,4,5,5,6,6- tridecafluorohexane, 1,1,1,2,2,3,3,4,4,5,5,6,6,7,7,8,8-heptadecafluorooctane, 1,1,1,2,3,3,3-heptafluoropropane, 1,1,1,2,3,3,4,4-octafluoro-2-trifluoromethylbutane, 1,1,1,2,3,3,4,4,5,5,6,6-dodecafluoro-2-trifluoromethylhexane, 1,1,2,2-tetrafluoroethane, 1,1,2,2,3,3,4,4- octafluorobutane, and 1,1,2,2,3,3,4,4,5,5,6,6-dodecafluorohexane.

Examples thereof include, as alkyl acrylates, nonyl acrylate, decyl acrylate, undecyl acrylate, dodecyl acrylate, tridecyl acrylate, tetradecyl acrylate, pentadecyl acrylate, hexadecyl acrylate, heptadecyl acrylate, octadecyl acrylate, and isooctadecyl acrylate.

Examples thereof include, as alkyl methacrylates, nonyl methacrylate, decyl methacrylate, undecyl methacrylate, dodecyl methacrylate, tridecyl methacrylate, tetradecyl methacrylate, pentadecyl methacrylate, hexadecyl methacrylate, heptadecyl methacrylate, and octadecyl methacrylate.

The contents of the ink repellency-imparting components in the water-based ink are preferably from 0.1% by mass or more, more preferably 0.3% by mass or more, and further preferably 0.5% by mass or more so that in that resistance to scumming can be improved. Further, in order to prevent the loss of long-term stability of the ink, it is preferably 20% by mass or less, more preferably 15% by mass or less, and further preferably 10% by mass or less.

### EXAMPLES

The invention will be further described below in detail with reference to the Examples below. However, the invention is not limited thereto.

### (EXAMPLE 1)

A lithographic printing plate original was produced by the production method described below.

The following heat insulating layer composition liquid-1 was applied onto a degreased aluminum substrate of 0.30 mm in thickness (Mitsubishi Aluminum Co., Ltd.), and was dried at 200°C for 90 seconds, thereby forming a heat insulating layer-1 having a film thickness of 6.0 µm. The heat insulating layer composition liquid-1 was obtained by mixing the following components during stirring at room temperature.

### <Heat-insulating layer composition liquid-1>

(a) active hydrogen-containing polymer: epoxy resin: "Epikote®" 1010 (Japan Epoxy Resins Co., Ltd.): 35 parts by mass
(b) active hydrogen-containing polymer: polyurethane: "Sanprene®" LQ-T1331D (Sanyo Chemical Industries Ltd.; solid component concentration: 20% by mass): 375 parts by mass
(c) alumichelate: "Alumichelate" ALCH-TR (Kawaken Fine Chemicals Co., Ltd.): 10 parts by mass
(d) levelling agent: "Disparlon®" LC951 (Kusumoto Chemical Co., Ltd.; solid component concentration: 10% by mass): 1 part by mass
(e) titanium oxide: N,N-dimethylformamide dispersion (titanium oxide: 50% by mass) of "Tipaque®" CR-50 (Ishihara Sangyo Kaisya, Ltd.): 60 parts by mass
(f) N,N-dimethylformamide: 730 parts by mass
(g) methyl ethyl ketone: 250 parts by mass

Then, the following heat sensitive layer composition liquid was applied onto the heat insulating layer and dried at 140°C for 80 seconds, thereby forming a heat sensitive layer-1 of 1.2 µm in average film thickness. The heat sensitive layer composition liquid was obtained by mixing the following components during stirring at room temperature.

### <Heat sensitive layer composition liquid -1>

(a) infrared-absorbing dye: "PROJET" 825LDI (Avecia): 13.2 parts by mass
(b) organic complex compound: titanium-n-butoxidebis(acetylacetonate): "Na̅cem® Titan" (Nippon Kagaku Sangyo Co.; concentration: 73% by mass; containing the following solvent: n-butanol: 27% by mass): 36.5 parts by mass
(c) phenol formaldehyde novolac resin: "Sumilite Resin®" PR53195 (Sumitomo Bakelite Co., Ltd.): 99 parts by mass
(d) polyurethane: "Nippolan®" 5196 (Nippon Polyurethane Industry Co., Ltd.; concentration: 30% by mass; containing the following solvents: methyl ethyl ketone: 35% by mass; cyclohexanone: 35% by mass): 132 parts by mass
(e) tetrahydrofuran: 1303.6 parts by mass

Then, the following ink repelling layer composition liquid-1 that had been prepared immediately before use was applied onto the heat sensitive layer, and the coating film was heated at 140°C for 80 seconds so as to form an ink repelling layer-1 of 2.4 µm in average film thickness. Thus, a lithographic printing plate original was obtained. The ink repelling layer composition liquid-1 was obtained by mixing the following components during stirring at room temperature.

### <Ink repelling layer composition liquid-1>

(a) isoparaffin type hydrocarbon solvent "Isopar®" E (Esso Chemical K.K.): 900 parts by mass
(b) α,ω-divinyl polydimethylsiloxane: TF22 (Dow Corning Toray Co., Ltd.): 77.30 parts by mass
(c) methyhydrogensiloxane HMS301 (GELEST Inc.): 3 parts by mass
(d) vinyltris(methyl ethyl ketoxime)silane: 0.88 parts by mass
(e)KF-96-10000cs (Shin-Etsu Silicones): 12.70 parts by mass
(f) platinum catalyst: "SRX-212" (Dow Corning Toray Co., Ltd.): 6.17 parts by mass

Here, according to the invention, a condition in which the boiling point of an ink repelling liquid is 150°C or more is defined as a condition in which a decrease in mass after static placement for 1 hour in an environment at 1 atmospheric pressure is less than 0.5% by mass. In order to confirm the boiling point of (e) KF-96-10000 cs (Shin-Etsu Silicones), 2 g of the liquid was weighed in an aluminium cup having a diameter of 50 mm and allowed to stand still in an oven at 150°C for 1 hour, and then a decrease in mass was determined. Based on the proportion of the decrease in mass, the liquid was confirmed to have a boiling point of 150°C or more.

The lithographic printing plate original was fixed to a platemaker: Plate Rite-8800 (Dainippon Screen Mfg., Co., Ltd.). A solid image of 10 cm x 10 cm in size was exposed to light using a semiconductor laser (wavelength: 830 nm) at an irradiation energy of 125 mJ/cm². Subsequently, using an automatic processor "TWL-1160" (Toray Industries Inc.; the pre-treatment liquid (45°C): CP-Y (Toray Industries Inc.); the developer (room temperature): water; the post-treatment liquid (room temperature): "PA-1" (Toray Industries Inc.)), the exposed plate was developed at a delivery speed of 80 cm/minute, thereby obtaining a lithographic printing plate.

### <Water-based ink-1>

As a pigment, 18 parts by mass of carbon black (color index: PBK7), 30 parts by mass of a styrene/acrylic acid/ethyl carbitol acrylate copolymer resin (acid number: 120; weight average molecular weight: about 22,000), 47 parts by mass of ion-exchange water, 0.1 parts by mass of AQUALEN 8021N (Kyoeisha Chemical Co., Ltd.), and 4.9 parts by mass of tripropylene glycol monobutyl ether were mixed at room temperature during stirring for 5 hours. Thus, a water-based ink-1 was obtained.

### <Evaluation of printing>

The lithographic printing plate obtained above was fixed to an offset press (OLIVER 266EPZ, Sakurai Graphic Systems Corporation). Continuous printing of high-quality paper was conducted by controlling the amount of the water-based ink-1 to result in a black color density of 1.8 on the solid image printed material.

### (1) Water-based ink resistance

The number of sheets of printed material available for continuous printing with a water-based ink was evaluated by visual observation of scumming on the printed material and the damage state of the lithographic printing plate. As a result, no scumming on the printed material and no damage to the lithographic printing plate were observed up to 50,000 sheets, meaning that continuous printing was possible.

### (2) Inking performance of water-based ink

After continuous printing of 10,000 sheets of high-quality paper with the water-based ink, the black color density on the solid image printed material was measured using reflectance densitometer (GretagMacbeth; SpectroEye) so as to evaluate inking performance of the water-based ink based on a decrease in the black color density. As the black color density after continuous printing of 10,000 sheets decreases, inking performance of water-based ink increases. The black color density after continuous printing of 10,000 was 1.6 with a decrease in the concentration of 0.2, indicating that inking performance was good.

### (3) Determination of scumming start temperature

During the above continuous printing, the ink roller temperature was controlled using a chiller so as to change the plate surface temperature of the lithographic printing plate. If there is no scumming on a lithographic printing plate even when the plate surface temperature is high, it means that the lithographic printing plate has good scumming resistance. The plate surface temperature was measured using a non-contact thermometer. The temperature at which scumming started to be observed in non-imaging areas was 30°C.

### <Washability against water-based ink>

It was possible to completely remove the water-based ink remaining on the roller by passing 1 L of water through the press twice after the termination of printing. In addition, it was possible to completely remove the water-based ink remaining on the roller by passing 1 L of washing water ("Magiclean®" (Kao Corporation); 10% by mass aqueous solution; pH: 10.9) through the press once.

### <Evaluation of image reproducibility>

The lithographic printing plate original was fixed to a platemaker: PlateRite-8800 (Dainippon Screen Mfg., Co., Ltd.) so as to expose 1, 2, 3, 4, 5, 10, 20, 30, 40, 50, 60, 70, 80, 90, 95, 96, 97, 98, or 99% of halftone dots to light using a semiconductor laser (wavelength: 830nm) at an irradiation energy of 125 mJ/cm² at a resolution of 2400 dpi and 175 lines per inch (lpi). Subsequently, using an automatic processor "TWL-1160" (Toray Industries Inc.; the pre-treatment liquid (45°C): CP-Y (Toray Industries Inc.); the developer (room temperature): water; the post-treatment liquid (room temperature): "PA-1" (Toray Industries Inc.)), the exposed plate was developed at a delivery speed of 80 cm/minute, thereby obtaining a lithographic printing plate. The halftone dots of the lithographic printing plate were observed through a magnifying glass so as to evaluate reproducibility of each halftone dot. All of 1% to 99% halftone dots were reproduced, exhibiting good image reproducibility.

### (EXAMPLE 2)

A printing plate was prepared, exposed, and developed so as to be evaluated on printing and image reproducibility as described in Example 1 except that the ink repelling layer composition liquid-1 was replaced by the following ink repelling layer composition liquid-2.

### <Ink repelling layer composition liquid -2>

(a) "Isopar®" E (Esso Chemical K.K.): 900 parts by mass
(b) both-terminal-hydroxyl polydimethylsiloxan: TF1 (Dow Corning Toray Co., Ltd.): 78.56 parts by mass
(c) methyltris(acetoxy)silane: 1.28 parts by mass
(d) vinyltris (methyl ethyl ketoxime)silane: 0.49 parts by mass
(e) KF-96-10000 cs (Shin-Etsu Silicones): 19.64 parts by mass
(f) dibutyltindiacetate: 0.03 parts by mass.

Evaluation results of water-based ink resistance, inking performance of water-based ink, scumming start temperature, and image reproducibility were as listed in the tables below.

### (EXAMPLE 3)

A printing plate was prepared, exposed, and developed so as to be evaluated on printing and image reproducibility as described in Example 1 except that the ink repelling layer composition liquid -1 and the heat sensitive layer composition liquid - 1 used in Example 1 were replaced by the following ink repelling layer composition liquid -3 and the following heat sensitive layer composition liquid -2, respectively.

### <Heat sensitive layer composition liquid-2>

(a) infrared-absorbing dye: "PROJET" 825LDI (Avecia): 16 parts by mass
(b) organic complex compound: titanium-n-butoxidebis (acetylacetonate): "Na̅cem® Titan" (Nippon Kagaku Sangyo Co.; concentration: 73% by mass; containing the following solvent: n-butanol: 27% by mass): 37.5 parts by mass
(c) phenol formaldehyde novolac resin: "Sumilite Resin®" PR53195 (Sumitomo Bakelite Co., Ltd.): 60 parts by mass
(d) urethane resin "Sanprene®" LQ-T1331D (Sanyo Chemical Industries Ltd.; solid component concentration: 20% by mass; containing the following solvent: N,N-dimethylformamide/2-ethoxyethanol): 125 parts by mass
(e) 3-glycidoxypropyl trimethoxysilane: 15 parts by mass
(f) tetrahydrofuran: 993 parts by mass
(g) ethanol: 64 parts by mass

### <Ink repelling layer composition liquid -3>

(a) "Isopar®" E (Esso Chemical K.K.): 1222 parts by mass
(b) α,ω-divinylpolydimethylsiloxane: DMS-V52 (GELEST Inc.): 100 parts by mass
(c) both-terminal-methyl(methyhydrogensiloxane) (dimethylsiloxane) copolymer, SiH group-containing polysiloxane HMS-151 (GELEST Inc.): 4 parts by mass
(d) vinyltris(methyl ethyl ketoxime)silane: 3 parts by mass
(e) platinum catalyst: "SRX-212" (Dow Corning Toray Co., Ltd.): 10 parts by mass Evaluation results of water-based ink resistance, inking performance of water-based ink, scumming start temperature, and image reproducibility were as listed in the tables below.

### (EXAMPLE 4)

A printing plate was prepared, exposed, and developed so as to be evaluated on printing and image reproducibility as described in Example 1 except that the ink repelling layer composition liquid-1 was replaced by the following ink repelling layer composition liquid-4.

### <Ink repelling layer composition liquid -4>

(a) "Isopar®" E (Esso Chemical K.K.): 900 parts by mass
(b) α,ω-divinyl polydimethylsiloxane: TF22 (Dow Corning Toray Co., Ltd.): 67.30 parts by mass
(c) methyhydrogensiloxane HMS301 (GELEST Inc.): 1.50 parts by mass
(d) vinyltris(methyl ethyl ketoxime)silane: 1.20 parts by mass
(e) KF-96-10000 cs (Shin-Etsu Silicones): 24.00 parts by mass
(f) platinum catalyst: "SRX-212" (Dow Corning Toray Co., Ltd.): 6.00 parts by mass

Evaluation results of water-based ink resistance, inking performance of water-based ink, scumming start temperature, and image reproducibility were as listed in the tables below.

### (EXAMPLE 5)

A printing plate was prepared, exposed, and developed so as to be evaluated on printing and image reproducibility as described in Example 1 except that the ink repelling layer composition liquid-1 was replaced by the following ink repelling layer composition liquid-5.

### <Ink repelling layer composition liquid -5>

(a) "Isopar®" E (Esso Chemical K.K.): 900 parts by mass
(b) α,ω-divinyl polydimethylsiloxane: TF22 (Dow Corning Toray Co., Ltd.): 63.00 parts by mass
(c) methyhydrogensiloxane HMS301 (GELEST Inc.): 1.30 parts by mass
(d) vinyltris(methyl ethyl ketoxime)silane: 0.70 parts by mass
(e) KF-96-10000 cs (Shin-Etsu Silicones): 29.00 parts by mass
(f) platinum catalyst: "SRX-212" (Dow Corning Toray Co., Ltd.): 6.00 parts by mass

Evaluation results of water-based ink resistance, inking performance of water-based ink, scumming start temperature, and image reproducibility were as listed in the tables below.

### (EXAMPLE 6)

A printing plate was prepared, exposed, and developed so as to be evaluated on printing and image reproducibility as described in Example 1 except that the ink repelling layer composition liquid-1 was replaced by the following ink repelling layer composition liquid-6.

### <Ink repelling layer composition liquid -6>

(a) "Isopar®" E (Esso Chemical K.K.): 900 parts by mass
(b) α,ω-divinyl polydimethylsiloxane: TF22 (Dow Corning Toray Co., Ltd.): 57. 00 parts by mass
(c) methyhydrogensiloxane HMS301 (GELEST Inc.): 1.20 parts by mass
(d) vinyltris(methyl ethyl ketoxime)silane: 0.80 parts by mass
(e) KF-96-10000 cs (Shin-Etsu Silicones): 35.00 parts by mass
(f) platinum catalyst: "SRX-212" (Dow Corning Toray Co., Ltd.): 6.00 parts by mass

Evaluation results of water-based ink resistance, inking performance of water-based ink, scumming start temperature, and image reproducibility were as listed in the tables below.

### (EXAMPLES 8, 9, 11 and 12 and REFERENCE EXAMPLES¹ 7 and 10)

A printing plate was prepared, exposed, and developed so as to be evaluated on printing and image reproducibility as described in Example 1 except that the heat sensitive layer used in Example 3 was replaced by the following heat sensitive layer composition liquid.

### <Heat sensitive layer composition liquid-3> (Reference)

(a) infrared-absorbing dye: "PROJET" 825LDI (Avecia): 16.0 parts by mass
(b) organic complex compound: titanium-n-butoxidebis(acetylacetonate): "Na̅cem® Titan" (Nippon Kagaku Sangyo Co.; concentration: 73% by mass; containing the following solvent: n-butanol: 27% by mass): 54.8 parts by mass
(c) phenol formaldehyde novolac resin: "Sumilite Resin®" PR53195 (Sumitomo Bakelite Co., Ltd.): 60 parts by mass
(d) polyurethane: "Nippolan®" 5196 (Nippon Polyurethane Industry Co., Ltd.; concentration: 30% by mass; containing the following solvents: methyl ethyl ketone: 35% by mass; cyclohexanone: 35% by mass): 80 parts by mass
(e) tetrahydrofuran: 809 parts by mass

### <Heat sensitive layer composition liquid-4>

(a) infrared-absorbing dye: "PROJET" 825LDI (Avecia): 16.0 parts by mass
(b) organic complex compound: titanium-n-butoxidebis(acetylacetonate): "Na̅cem® Titan" (Nippon Kagaku Sangyo Co.; concentration: 73% by mass; containing the following solvent: n-butanol: 27% by mass): 20.5 parts by mass
(c) phenol formaldehyde novolac resin: "Sumilite Resin®" PR53195 (Sumitomo Bakelite Co., Ltd.): 60 parts by mass
(d) polyurethane: "Nippolan®" 5196 (Nippon Polyurethane Industry Co., Ltd.; concentration: 30% by mass; containing the following solvents: methyl ethyl ketone: 35% by mass; cyclohexanone: 35% by mass): 80 parts by mass
(e) tetrahydrofuran: 807 parts by mass

### <Heat sensitive layer composition liquid-5>

(a) infrared-absorbing dye: "PROJET" 825LDI (Avecia): 16.0 parts by mass
(b) organic complex compound: titanium-n-butoxidebis(acetylacetonate): "Na̅cem® Titan" (Nippon Kagaku Sangyo Co.; concentration: 73% by mass; containing the following solvent: n-butanol: 27% by mass): 14.9 parts by mass
(c) phenol formaldehyde novolac resin: "Sumilite Resin®" PR53195 (Sumitomo Bakelite Co., Ltd.): 60 parts by mass
(d) polyurethane: "Nippolan®" 5196 (Nippon Polyurethane Industry Co., Ltd.; concentration: 30% by mass; containing the following solvents: methyl ethyl ketone: 35% by mass; cyclohexanone: 35% by mass): 80 parts by mass
(e) tetrahydrofuran: 799 parts by mass

### <Heat sensitive layer composition liquid-6> (Reference)

(a) infrared-absorbing dye: "PROJET" 825LDI (Avecia): 16.0 parts by mass
(b) organic complex compound: titanium-n-butoxidebis(acetylacetonate): "Na̅cem® Titan" (Nippon Kagaku Sangyo Co.; concentration: 73% by mass; containing the following solvent: n-butanol: 27% by mass): 12.6 parts by mass
(c) phenol formaldehyde novolac resin: "Sumilite Resin®" PR53195 (Sumitomo Bakelite Co., Ltd.): 60 parts by mass
(d) polyurethane: "Nippolan®" 5196 (Nippon Polyurethane Industry Co., Ltd.; concentration: 30% by mass; containing the following solvents: methyl ethyl ketone: 35% by mass; cyclohexanone: 35% by mass): 80 parts by mass
(e) tetrahydrofuran: 795 parts by mass

### <Heat sensitive layer composition liquid-7>

(a) infrared-absorbing dye: "PROJET" 825LDI (Avecia): 13.2 parts by mass
(b) organic complex compound: titanium-n-butoxidebis(acetylacetonate): "Na̅cem® Titan" (Nippon Kagaku Sangyo Co.; concentration: 73% by mass; containing the following solvent: n-butanol: 27% by mass): 36.5 parts by mass
(c) phenol formaldehyde novolac resin: "Sumilite Resin®" PR53195 (Sumitomo Bakelite Co., Ltd.): 63 parts by mass
(d) polyurethane: "Nippolan®" 5196 (Nippon Polyurethane Industry Co., Ltd.; concentration: 30% by mass; containing the following solvents: methyl ethyl ketone: 35% by mass; cyclohexanone: 35% by mass): 233 parts by mass
(e) tetrahydrofuran: 1303.6 parts by mass

### <Heat sensitive layer composition liquid-8>

(a) infrared-absorbing dye: "PROJET" 825LDI (Avecia): 13.2 parts by mass
(b) organic complex compound: titanium-n-butoxidebis(acetylacetonate): "Na̅cem® Titan" (Nippon Kagaku Sangyo Co.; concentration: 73% by mass; containing the following solvent: n-butanol: 27% by mass): 36.5 parts by mass
(c) phenol formaldehyde novolac resin: "Sumilite Resin®" PR53195 (Sumitomo Bakelite Co., Ltd.): 99 parts by mass
(d) polyurethane: "Nippolan®" 5196 (Nippon Polyurethane Industry Co., Ltd.; concentration: 30% by mass; containing the following solvents: methyl ethyl ketone: 35% by mass; cyclohexanone: 35% by mass): 60 parts by mass (e) tetrahydrofuran: 1303.6 parts by mass

Evaluation results of water-based ink resistance, inking performance of water-based ink, scumming start temperature, and image reproducibility were as listed in the tables below.

### (EXAMPLE 13)

A printing plate was prepared, exposed, and developed so as to be evaluated on printing and image reproducibility as described in Example 1 except that the water-based ink-1 used in Example 1 was replaced by the following water-based ink-2.

### <Water-based ink-2>

As a pigment, 15 parts by mass of carbon black (color index: PBK7), 20 parts by mass of styrene/acrylic acid/ethyl carbitol acrylate copolymer resin (acid number: 120; weight average molecular weight: about 22,000), 65 parts by mass of "Miramer®" M4004 (Toyo Chemicals Co., Ltd.) as a water-soluble acrylic monomer, and 0.1 parts by mass of hydroquinone monomethyl ether were mixed at room temperature during stirring for 5 hours. Thus, a water-based ink-2 was obtained.

Evaluation results of water-based ink resistance, inking performance of water-based ink, scumming start temperature, and image reproducibility were as listed in the tables below. Favorable results were obtained for each item with the use of the water-soluble acrylic monomer as a diluent. It was possible to completely remove the water-based ink remaining on the roller by passing 1 L of water through the press three times after the termination of printing. In addition, it was possible to completely remove the water-based ink remaining on the roller by passing 1 L of washing water ("Magiclean®" (Kao Corporation); 10% by mass aqueous solution; pH: 10.9) through the press once.

### (EXAMPLES 14-16)

A printing plate was prepared, exposed, and developed so as to be evaluated on printing and image reproducibility as described in Example 1 using the heat-insulating layer composition liquids, the heat sensitive layer composition liquids, the ink repelling layer composition liquids, and the water-based inks listed in the tables. Evaluation results of water-based ink resistance, inking performance of water-based ink, scumming start temperature, and image reproducibility were as listed in the tables below.

### (COMPARATIVE EXAMPLE 1)

A lithographic printing plate original was produced by the production method described below.

The following heat insulating layer composition liquid-2 was applied onto a degreased aluminum substrate of 0.30 mm in thickness (Mitsubishi Aluminum Co., Ltd.), and was dried at 230°C for 60 seconds, thereby forming a heat insulating layer-2 having a film thickness of 3 µm. The heat insulating layer composition liquid-2 was obtained by mixing the following components during stirring at room temperature.

### <Heat-insulating layer composition liquid-2>

(a) epoxy resin: "Epikote®" 827 (by Japan Epoxy Resins Co.,ltd.): 10 parts by mass
(b) urethane resin: "Sanprene®" LQ-SZ18 (Sanyo Chemical Industries Ltd.): 115 parts by mass
(c) butylated urea resin: 20 parts by mass
(d) oxidized titanium: 10 parts by mass
(e) N,N-dimethylformamide: 750 parts by mass
(f) isocyanate: "Desmodur®" CT Staple (Sumitomo Bayer Urethane Co., Ltd.): 20 parts by mass

Then, the following photosensitive layer composition liquid-1 was applied onto the heat insulating layer and dried at 115°C for 60 seconds, thereby forming a photosensitive layer-1 of 1.5 µm in average film thickness. In addition, the photosensitive layer composition liquid-1 was obtained by mixing the following components during stirring at room temperature.

### <Photosensitive layer composition liquid -1>

(a) partial ester compound of 1,2-naphthoquinone-2-diazido-5-sulfonate chloride and a novolac resin: "Sumilite Resin®" PR50622 (Sumitomo Bakelite Co., Ltd.) (degree of esterification: 36 mol%): 70 parts by mass
(b) urethane resin "Miractran" P22S (Nippon Miractran Co., Ltd.): 30 parts by mass
(c) isocyanate: "CHEMIOX®" KA053 (Sanyo Chemical Industries Ltd.): 21 parts by mass
(d) dibutyltin diacetate: 0.2 part by mass
(e) p-toluenesulfonic acid: 0.8 parts by mass
(f) tetrahydrofuran: 800 parts by mass

Then, the following ink repelling layer composition liquid-7 that had been prepared immediately before use was applied onto the heat sensitive layer, and the coating film was heated at 115°C for 210 seconds so as to form an ink repelling layer-7 of 2.0 µm in average film thickness. Thus, a lithographic printing plate original was obtained. The ink repelling layer composition liquid-7 was obtained by mixing the following components during stirring at room temperature.

### <Ink repelling layer composition liquid -7>

(a) "Isopar®" E (Esso Chemical K.K.): 800 parts by mass
(b) α,ω-divinyl polydimethylsiloxane: "TF22" (Dow Corning Toray Co., Ltd.): 100 parts by mass
(d) vinyltris(methyl ethyl ketoxime)silane: 10 parts by mass

The obtained lithographic printing plate original was subjected to whole image exposure for 6 seconds at an irradiation energy of 11 mW/cm² using a metal halide lamp: Idlefin-2000 (Iwasaki Electric Co., Ltd.). Further, vacuum contact of a negative film having a 10 cm x 10 cm solid image was conducted on the lithographic printing plate original, followed by light exposure for 60 seconds at the aforementioned level of irradiation energy. Subsequently, using an automatic processor "TWL-1160" (Toray Industries Inc.; the pre-treatment liquid (45°C): CP-Y (Toray Industries Inc.); the developer (room temperature): water; the post-treatment liquid (room temperature): "PA-1" (Toray Industries Inc.)), the exposed plate was developed at a delivery speed of 60 cm/minute, thereby obtaining a lithographic printing plate.

### <Water-based ink-1>

As a pigment, 18 parts by mass of carbon black (color index: PBK7), 30 parts by mass of styrene/acrylic acid/ethyl carbitol acrylate copolymer resin (acid number: 120; weight average molecular weight: about 22,000), 47 parts by mass of ionexchange water, 0.1 parts by mass of AQUALEN 8021N (Kyoeisha Chemical Co., Ltd.), and 4.9 parts by mass of tripropylene glycol monomethyl ether were mixed at room temperature during stirring for 5 hours. Thus, a water-based ink was obtained.

### <Evaluation of printing>

The lithographic printing plate obtained above was fixed to an offset press (OLIVER 266EPZ, Sakurai Graphic Systems Corporation). Continuous printing of high-quality paper was conducted by controlling the amount of the water-based ink-1 to result in a black color density of 1.8 on the solid image printed material.

### (1) Water-based ink resistance

The number of sheets of printed material available for continuous printing with a water-based ink was evaluated by visual observation of scumming on the printed material and the damage state of the lithographic printing plate. As a result, no scumming on the printed material and no damage to the lithographic printing plate were observed up to 10,000 sheets, meaning that continuous printing was possible.

### (2) Inking performance of water-based ink

After continuous printing of 10,000 sheets of high-quality paper with the water-based ink, the black color density on the solid image printed material was measured using reflectance densitometer (GretagMacbeth; SpectroEye) so as to evaluate inking performance of the water-based ink based on a decrease in the black color density. As the black color density after continuous printing of 10,000 sheets decreases, inking performance of water-based ink increases. After continuous printing of 10,000 sheets, the reflection density was 1.2, and a decrease in the concentration was 0.6, which was significant, indicating that inking performance sharply declined.

### (3) Determination of scumming start temperature

During the above continuous printing, the ink roller temperature was controlled using a chiller so as to change the plate surface temperature of the lithographic printing plate. If there is no scumming on a lithographic printing plate even when the plate surface temperature is high, it means that the lithographic printing plate has good scumming resistance. The plate surface temperature was measured using a non-contact thermometer. The temperature at which scumming started to be observed in non-imaging areas was 28°C.

### <Evaluation of image reproducibility>

The obtained lithographic printing plate original was subjected to whole image exposure for 6 seconds at an irradiation energy of 11 mW/cm² using a metal halide lamp: Idlefin-2000 (Iwasaki Electric Co., Ltd.). Further, vacuum contact of a negative film having 1, 2, 3, 4, 5, 10, 20, 30, 40, 50, 60, 70, 80, 90, 95, 96, 97, 98, or 99% of halftone dots was conducted on the lithographic printing plate original, followed by light exposure for 60 seconds at the aforementioned level of irradiation energy. Subsequently, using an automatic processor "TWL-1160" (Toray Industries Inc.; the pre-treatment liquid (45°C): CP-Y (Toray Industries Inc.); the developer (room temperature): water; the post-treatment liquid (room temperature): "PA-1" (Toray Industries Inc.), the exposed plate was developed at a delivery speed of 80 cm/minute, thereby obtaining a lithographic printing plate. The halftone dots of the lithographic printing plate were observed through a magnifying glass so as to evaluate reproducibility of each halftone dot. 3 to 98% of halftone dots were reproduced.

### (COMPARATIVE EXAMPLE 2)

A printing plate was prepared, exposed, and developed so as to be evaluated on printing and image reproducibility as described in Comparative Example 1 except that the water-based ink-1 used in the Comparative Example 1 was replaced by the water-based ink-2. Evaluation results of water-based ink resistance, inking performance of water-based ink, scumming start temperature, and image reproducibility were as listed in the tables below.

The tables below list the composition of each component used in the Examples and Comparative Examples and evaluation results.

### [Table 1]

**[Table 1]**

| | Item | Example 1 | Example 2 | Example 3 | Example 4 | Example 5 | Example 6 | Reference Example 7 | Example 8 | Example 9 |
|---|---|---|---|---|---|---|---|---|---|---|
| Plate Composition | Ink repelling layer | 1 | 2 | 3 | 4 | 5 | 6 | 3 | 3 | 3 |
| | Heat sensitive layer | 1 | 1 | 2 | 1 | 1 | 1 | 3 | 4 | 5 |
| | Photosensitive layer | - | - | - | - | - | - | - | - | - |
| | Heat insulating layer | 1 | 1 | 1 | 1 | 1 | 1 | 1 | 1 | 1 |
| | Water-based ink | 1 | 1 | 1 | 1 | 1 | 1 | 1 | 1 | 1 |
| Evaluation | No. of printable sheets for continuous printin | 50.000 | 50.000 | 35.000 | 50.000 | 40.000 | 35.000 | 25.000 | 35.000 | 35.000 |
| | Decrease in reflection density | 0,2 | 0,2 | 0,2 | 0,2 | 0,2 | 0,2 | 0,4 | 0,2 | 0,2 |
| | Scumming start temperature | 31°C | 31°C | 28°C | 32°C | 32°C | 32°C | 28°C | 28°C | 28°C |
| | Image reproducibility | 1-99% | 1-99% | 1-99% | 1-99% | 1-99% | 1-99% | 3-98% | 1-99% | 1-99% |

### [Table 2]

**[Table 2]**

| | Item | Reference Example 10 | Example 11 | Example 12 | Example 13 | Example 14 | Example 15 | Example 16 | Comparative Example 1 | Comparative Example 2 |
|---|---|---|---|---|---|---|---|---|---|---|
| Plate Composition | Ink repelling layer | 3 | 3 | 3 | 1 | 4 | 5 | 6 | 7 | 7 |
| | Heat sensitive layer | 6 | 7 | 8 | 1 | 1 | 1 | 1 | - | - |
| | Photosensitive layer | - | - | - | - | - | - | - | 1 | 1 |
| | Heat insulating layer | 1 | 1 | 1 | 1 | 1 | 1 | 1 | 2 | 2 |
| | Water-based ink | 1 | 1 | 1 | 2 | 2 | 2 | 2 | 1 | 2 |
| Evaluation | No. of printable sheets for continuous printing | 25.000 | 35.000 | 35.000 | 80.000 | 80.000 | 70.000 | 50.000 | 10.000 | 13.000 |
| | Decrease in reflection density | 0,4 | 0,3 | 0,3 | 0 | 0 | 0 | 0 | 0,6 | 0,4 |
| | Scumming start temperature | 28°C | 28°C | 28°C | 34°C | 35°C | 35°C | 35°C | 28°C | 29°C |
| | Image reproducibility | 1-99% | 1-99% | 1-99% | 1-99% | 1-99% | 1-99% | 1-99% | 5 - 95% | 3 - 98% |

### REFERENS SIGNS LIST

- 1: ink roller
- 2: lithographic printing plate
- 3: plate cylinder
- 4: blanket
- 5: printing substrate
- 6: support roller

## Claims

1. A method of producing a printed material, comprising the steps of: allowing a water-based ink to adhere to a surface of a heat sensitive layer of a lithographic printing plate having a surface on which an ink repelling layer and the heat sensitive layer exist; and transferring the adhering water-based ink directly or via a blanket to a printing substrate,
wherein the heat sensitive layer contains a novolac resin and an organic complex compound, and the heat sensitive layer contains the novolac resin and the organic complex compound at a mass ratio of 2 to 6.

2. The method of producing a printed material according to claim 1, wherein the heat sensitive layer contains a photothermal conversion material.

3. The method of producing a printed material according to claim 1 or 2, wherein the ink repelling layer contains a silicone rubber.

4. The method of producing a printed material according to any one of claims 1 to 3, wherein the ink repelling layer contains an ink repelling liquid, and the content of the ink repelling liquid is from 10% by mass to 50% by mass.

5. The method of producing a printed material according to claim 4, wherein the ink repelling liquid in the ink repelling layer has a boiling point of 150°C or more at 1 atmospheric pressure.

6. The method of producing a printed material according to claim 4 or 5, wherein the ink repelling liquid is a hydrocarbon-based solvent or a silicone-based liquid.

7. The method of producing a printed material according to any one of claims 1 to 5, further comprising the step of irradiating the lithographic printing plate original having the ink repelling layer and the heat sensitive layer with laser and applying physical stimulations thereto, thereby preparing the lithographic printing plate, prior to the step of allowing the water-based ink to adhere to the surface of the heat sensitive layer of the lithographic printing plate.

8. The method of producing a printed material according to any one of claims 1 to 7, wherein the heat sensitive layer contains an urethane resin.

9. The method of producing a printed material according to claim 8, wherein the heat sensitive layer contains the novolac resin and the urethane resin at a mass ratio of 1 to 5.

10. The method of producing a printed material according to any one of claims 1 to 9, wherein the water-based ink contains a pigment, a water-soluble resin, and a diluent.

11. The method of producing a printed material according to claim 10, wherein the diluent contains a water-soluble acrylic monomer.

12. The method of producing a printed material according to any one of claims 1 to 11, further comprising the step of irradiating the water-based ink transferred to the printing substrate with an active energy ray after the step of transferring the water-based ink to the printing substrate.

13. A method of producing a printed material, comprising the step of washing a lithographic printing plate or a blanket with washing water after carrying out the steps of the method of producing a printed material according to any one of claims 1 to 12, wherein the washing water contains a surfactant.

## Patentansprüche

1. Verfahren zur Herstellung eines bedruckten Materials, umfassend die Schritte:
Anhaftenlassen einer Druckfarbe auf Wasserbasis an einer Oberfläche einer wärmeempfindlichen Schicht einer lithographischen Druckplatte, die eine Oberfläche aufweist, auf der eine farbabweisende Schicht und die wärmeempfindliche Schicht vorhanden sind; und Übertragen der anhaftenden Druckfarbe auf Wasserbasis direkt oder über ein Gummituch auf ein Drucksubstrat,
wobei die wärmeempfindliche Schicht ein Novolakharz und eine organische Komplexverbindung enthält und die wärmeempfindliche Schicht das Novolakharz und die organische Komplexverbindung in einem Massenverhältnis von 2 bis 6 enthält.

2. Verfahren zur Herstellung eines bedruckten Materials nach Anspruch 1, wobei die wärmeempfindliche Schicht ein photothermisches Umwandlungsmaterial enthält.

3. Verfahren zur Herstellung eines bedruckten Materials nach Anspruch 1 oder 2, wobei die farbabweisende Schicht einen Silikonkautschuk enthält.

4. Verfahren zur Herstellung eines bedruckten Materials nach einem der Ansprüche 1 bis 3, wobei die farbabweisende Schicht eine farbabweisende Flüssigkeit enthält und der Gehalt der farbabweisenden Flüssigkeit zwischen 10 Masse-% und 50 Masse-% beträgt.

5. Verfahren zur Herstellung eines bedruckten Materials nach Anspruch 4, wobei die farbabweisende Flüssigkeit in der farbabweisenden Schicht einen Siedepunkt von 150 °C oder mehr bei 1 Atmosphärendruck aufweist.

6. Verfahren zur Herstellung eines bedruckten Materials nach Anspruch 4 oder 5, wobei die farbabweisende Flüssigkeit ein Lösungsmittel auf Kohlenwasserstoffbasis oder eine Flüssigkeit auf Silikonbasis ist.

7. Verfahren zur Herstellung eines bedruckten Materials nach einem der Ansprüche 1 bis 5, des Weiteren umfassend den Schritt des Bestrahlens der lithografischen Druckplatte, die ursprünglich die farbabweisende Schicht und die wärmeempfindliche Schicht aufweist, mit einem Laser und des Anlegens physikalischer Reize daran, wodurch die lithografische Druckplatte vorbereitet wird, bevor man die Farbe auf Wasserbasis an der Oberfläche der wärmeempfindlichen Schicht der lithografischen Druckplatte anhaften lässt.

8. Verfahren zur Herstellung eines bedruckten Materials nach einem der Ansprüche 1 bis 7, wobei die wärmeempfindliche Schicht ein Urethanharz enthält.

9. Verfahren zur Herstellung eines bedruckten Materials nach Anspruch 8, wobei die wärmeempfindliche Schicht das Novolakharz und das Urethanharz in einem Massenverhältnis von 1 zu 5 enthält.

10. Verfahren zur Herstellung eines bedruckten Materials nach einem der Ansprüche 1 bis 9, wobei die Tinte auf Wasserbasis ein Pigment, ein wasserlösliches Harz und ein Verdünnungsmittel enthält.

11. Verfahren zur Herstellung eines bedruckten Materials nach Anspruch 10, wobei das Verdünnungsmittel ein wasserlösliches Acrylmonomer enthält.

12. Verfahren zur Herstellung eines bedruckten Materials nach einem der Ansprüche 1 bis 11, des Weiteren umfassend den Schritt des Bestrahlens der auf den Druckträger übertragenen Tinte auf Wasserbasis mit einem aktiven Energiestrahl nach dem Schritt des Übertragens der Tinte auf Wasserbasis auf den Druckträger.

13. Verfahren zur Herstellung eines bedruckten Materials, umfassend den Schritt des Waschens einer lithografischen Druckplatte oder eines Gummituchs mit Waschwasser nach Durchführung der Schritte des Verfahrens zur Herstellung eines bedruckten Materials nach einem der Ansprüche 1 bis 12, wobei das Waschwasser ein Tensid enthält.

## Revendications

1. Procédé de production d'un matériau imprimé, comprenant les étapes consistant à : laisser une encre à base d'eau adhérer à une surface d'une couche thermosensible d'une plaque d'impression lithographique ayant une surface sur laquelle une couche repoussant l'encre et la couche thermosensible existent ; et transférer l'encre à base d'eau adhérente directement ou par le biais d'un blanchet à un substrat d'impression, dans lequel la couche thermosensible contient une résine novolaque et un composé complexe organique, et la couche thermosensible contient la résine novolaque et le composé complexe organique en un rapport massique de 2 à 6.

2. Procédé de production d'un matériau imprimé selon la revendication 1, dans lequel la couche thermosensible contient un matériau de conversion photothermique.

3. Procédé de production d'un matériau imprimé selon la revendication 1 ou 2, dans lequel la couche repoussant l'encre contient un caoutchouc de silicone.

4. Procédé de production d'un matériau imprimé selon l'une quelconque des revendications 1 à 3, dans lequel la couche repoussant l'encre contient un liquide repoussant l'encre, et la teneur en le liquide repoussant l'encre est de 10 % en masse à 50 % en masse.

5. Procédé de production d'un matériau imprimé selon la revendication 4, dans lequel le liquide repoussant l'encre dans la couche repoussant l'encre a un point d'ébullition de 150 °C ou plus sous une pression de 1 atmosphère.

6. Procédé de production d'un matériau imprimé selon la revendication 4 ou 5, dans lequel le liquide repoussant l'encre est un solvant à base d'hydrocarbure ou un liquide à base de silicone.

7. Procédé de production d'un matériau imprimé selon l'une quelconque des revendications 1 à 5, comprenant en outre l'étape consistant à exposer l'original de la plaque d'impression lithographique ayant la couche repoussant l'encre et la couche thermosensible à un laser et à appliquer des stimulations physiques à celle-ci, ce qui permet de préparer la plaque d'impression lithographique, avant l'étape consistant à laisser l'encre à base d'eau adhérer à la surface de la couche thermosensible de la plaque d'impression lithographique.

8. Procédé de production d'un matériau imprimé selon l'une quelconque des revendications 1 à 7, dans lequel la couche thermosensible contient une résine d'uréthane.

9. Procédé de production d'un matériau imprimé selon la revendication 8, dans lequel la couche thermosensible contient la résine novolaque et la résine d'uréthane en un rapport de masse de 1 à 5.

10. Procédé de production d'un matériau imprimé selon l'une quelconque des revendications 1 à 9, dans lequel l'encre à base d'eau contient un pigment, une résine soluble dans l'eau et un diluant.

11. Procédé de production d'un matériau imprimé selon la revendication 10, dans lequel le diluant contient un monomère acrylique soluble dans l'eau.

12. Procédé de production d'un matériau imprimé selon l'une quelconque des revendications 1 à 11, comprenant en outre l'étape consistant à exposer l'encre à base d'eau transférée au substrat d'impression à un rayonnement à énergie active après l'étape consistant à transférer l'encre à base d'eau au substrat d'impression.

13. Procédé de production d'un matériau imprimé, comprenant l'étape consistant à laver une plaque d'impression lithographique ou un blanchet avec de l'eau de lavage après la réalisation des étapes du procédé de production d'un matériau imprimé selon l'une quelconque des revendications 1 à 12, dans lequel l'eau de lavage contient un tensioactif.
